# EUROPEAN PATENT APPLICATION

(11) **EP 4 428 902 A1**
(43) Date of publication of application: **11.09.2024**
(21) Application number: 22889612.2
(22) Date of filing: 29.06.2022
(51) Int. Cl.: H01L 21/365, H01L 21/368, C23C 16/455

(54) **FILM FORMING DEVICE, FILM FORMING METHOD, OXIDE SEMICONDUCTOR FILM AND MULTILAYER BODY**

(30) Priority: 02.11.2021 JP 2021179788
(71) Applicant: SHIN-ETSU CHEMICAL CO., LTD., Tokyo 1000005 (JP)
(72) Inventor: SAKATSUME, Takahiro, Annaka-shi, Gunma 379-0195 (JP)
(74) Representative: Mooser, Sebastian Thomas
(86) International application number: PCT/JP2022/026034
(87) International publication number: WO 2023/079787

(57) **Abstract**

The present invention provides a film forming apparatus including: an atomizer configured to atomize a raw material solution to generate a mist; a carrier gas supplier configured to supply a carrier gas that conveys the mist generated by the atomizer; and a film forming unit configured to heat the mist conveyed by the carrier gas to form a film. The film forming unit includes a substrate holder configured to hold the substrate, a nozzle located above the substrate holder and configured to supply the mist onto the substrate, a ceiling plate located above the substrate holder and configured to regulate a flow of the mist supplied from the nozzle, and sidewalls facing each other with the substrate holder interposed. When a difference in height position between a substrate holding surface of the substrate holder and a bottom surface of the ceiling plate is I [cm] and a shortest distance between a substrate holding region of the substrate holder and each of the sidewalls is J [cm], IJ≤15 holds. Thus, a film forming apparatus capable of forming a large-area film with excellent in-plane uniformity of film thickness distribution is provided.

## Description

### TECHNICAL FIELD

The present invention relates to a film forming apparatus and a film forming method, and an oxide semiconductor film and a laminate.

### BACKGROUND ART

High-vacuum film forming apparatuses capable of achieving a non-equilibrium state in pulsed laser deposition (PLD), molecular beam epitaxy (MBE), sputtering, or the like have been developed to enable fabrication of oxide semiconductors that conventional methods such as melt methods have been unable to fabricate. On the other hand, mist chemical vapor deposition (mist CVD, which hereinafter may be referred to as "mist CVD method") which grows crystals on a substrate using a raw material atomized into a mist has been developed to enable fabrication of oxide gallium (α-Ga₂O₃) having a corundum structure. α-Ga₂O₃ is expected as a semiconductor with a large band gap to be applied to next-generation switching devices that achieve high withstand voltage, low loss, and high heat resistance.

In connection with the mist CVD method, Patent Document 1 discloses a tubular furnace-type mist CVD apparatus. Patent Document 2 describes a fine channel-type mist CVD apparatus. Patent Document 3 describes a linear source-type mist CVD apparatus. Patent Document 4 describes a tubular furnace-type mist CVD apparatus, which differs from the mist CVD apparatus described in Patent Document 1 in that a carrier gas is introduced into a mist generator. Patent Document 5 describes a mist CVD apparatus in which a substrate is installed above a mist generator and the substrate is rotated.

### CITATION LIST

### PATENT LITERATURE

Patent Document 1: JP H01-257337 A
Patent Document 2: JP 2005-307238 A
Patent Document 3: JP 2012-46772 A
Patent Document 4: JP 5397794 B
Patent Document 5: WO 2020/261355 A1

### SUMMARY OF INVENTION

### TECHNICAL PROBLEM

Unlike other CVD methods, the mist CVD method can form a film at relatively low temperatures and can fabricate crystal structures in metastable phases, such as the corundum structure of α-Ga₂O₃. However, the inventors of the present invention have found a problem in which when a mist is supplied from above a substrate, thermal convection or a mixture of a mist-containing gas and an ambient gas disturbs a mist flow to make it difficult to maintain in-plane uniformity of film thickness distribution of a formed film. Semiconductor films with low in-plane uniformity lead to reduction in yield of fabricated semiconductor devices and increase in number of semiconductor device fabrication steps involving a polishing step.

Patent Document 5 discloses an example in which a semiconductor film with a good in-plane film thickness distribution is formed by supplying a mist to a substrate located above a mist generator while rotating the substrate. However, according to examples in this document, in film formation on a 4-inch (diameter 100 mm) substrate, the minimum film thickness/maximum film thickness is 55.0% and the film is not excellent in-plane uniformity of film thickness distribution. The inventors of the present invention conducted film formation based on Patent Document 5 and found that the film forming apparatus in this document only produced a film that was thick at the center and had poor in-plane uniformity of film thickness distribution. The inventors also found that when film formation was performed on a 6-inch (diameter 150 mm) substrate, the in-plane uniformity of film thickness distribution of the film was even worse.

The present invention was made to solve the above problem and is aimed to provide a large-area oxide semiconductor film with excellent in-plane uniformity of film thickness distribution and a laminate including such a film, as well as a film forming apparatus and a film forming method capable of forming a large-area film with excellent in-plane uniformity of film thickness distribution.

### SOLUTION TO PROBLEM

The present invention was made to achieve the above object and provides a film forming apparatus comprising: an atomizer configured to atomize a raw material solution to generate a mist; a carrier gas supplier configured to supply a carrier gas that conveys the mist generated by the atomizer; and a film forming unit configured to heat the mist conveyed by the carrier gas to form a film, wherein the film forming unit includes a substrate holder configured to hold the substrate, a nozzle located above the substrate holder and configured to supply the mist onto the substrate, a ceiling plate located above the substrate holder and configured to regulate a flow of the mist supplied from the nozzle, and sidewalls facing each other with the substrate holder interposed, and when a difference in height position between a substrate holding surface of the substrate holder and a bottom surface of the ceiling plate is I [cm] and a shortest distance between a substrate holding region of the substrate holder and each of the sidewalls is J [cm], IJ≤15 holds.

In such a film forming apparatus, the film forming apparatus has a simple structure and can form a film with good in-plane uniformity of film thickness distribution on a substrate by using a raw material solution in the form of a mist. Because of the synergistic action of the flow regulating effect by the ceiling plate and the flow regulating effect by the sidewalls, a uniform gas flow along the substrate (parallel to the substrate surface) is produced above the substrate to enable generation of a uniform film on the substrate.

In this film forming apparatus, all of the bottom surface of the ceiling plate, an opening surface of the nozzle, and the substrate holding surface may be parallel.

With this configuration, a film with even better in-plane uniformity of film thickness distribution can be formed.

In this film forming apparatus, the I [cm] may be 0.15 cm or more and 6.05 cm or less.

With this configuration, a film with even better in-plane uniformity of film thickness distribution can be formed.

In this film forming apparatus, the J [cm] may be 5.0 cm or less.

With this configuration, a film with even better in-plane uniformity of film thickness distribution can be formed.

In this film forming apparatus, when the bottom surface of the ceiling plate has an area of B [cm²], B≥40 may hold.

With this configuration, a film with even better in-plane uniformity of film thickness distribution can be formed.

In this film forming apparatus, when a surface to be processed of the substrate has an area of A [cm²] and the bottom surface of the ceiling plate has an area of B [cm²], B/A≥0.5 may hold.

With this configuration, a film with even better in-plane uniformity of film thickness distribution can be formed.

In this film forming apparatus, when surfaces of the sidewalls on the substrate holder side have an area of C [cm²], C≥20 may hold.

With this configuration, a film with even better in-plane uniformity of film thickness distribution can be formed.

In this film forming apparatus, when a surface to be processed of the substrate has an area of A [cm²] and facing surfaces of the sidewalls have an area of C [cm²], C/A≥0.2 may hold.

With this configuration, a film with even better in-plane uniformity of film thickness distribution can be formed.

This film forming apparatus may further comprise an exhaust unit configured to discharge an exhaust gas from the film forming unit.

With this configuration, a film with further better in-plane uniformity of film thickness distribution can be formed.

This film forming apparatus may further comprise a moving mechanism configured to move the substrate below the nozzle.

With this configuration, a film having a large area with good in-plane uniformity of film thickness distribution can be formed.

In this film forming apparatus, the film forming unit may include a film forming chamber, and the sidewalls may be walls of the film forming chamber.

With this configuration, the film forming apparatus has a simple structure.

In this film forming apparatus, the film forming unit may further include a film forming chamber configured to accommodate the substrate holder, the nozzle, the ceiling plate, and the sidewalls inside.

With this configuration, contamination due to impurities can be reduced.

The present invention was made to achieve the above object and provides a film forming method in which a film is formed on a substrate by heating a mist of a raw material solution, the film forming method comprising: a mist generating step of atomizing the raw material solution to generate a mist; a mist conveying step of conveying the mist to a film forming unit; and a film forming step of forming a film by supplying the mist onto the substrate placed on a substrate holder in the film forming unit from a nozzle located above the substrate holder, and heating the mist, wherein in the film forming step, the mist is supplied from the nozzle into a space surrounded by a ceiling plate provided above the substrate holder and by sidewalls facing each other with the substrate holder interposed, wherein a difference in height position between a substrate holding surface of the substrate holder and a bottom surface of the ceiling plate is I [cm], and a shortest distance between a substrate holding region of the substrate holder and each of the sidewalls is J [cm], wherein the ceiling plate and the sidewalls are provided such that IJ≤15 holds.

With such a film forming method, a film with good in-plane uniformity of film thickness distribution can be formed on a substrate by using a raw material solution in the form of a mist by a simple method. Because of the synergistic action of the flow regulating effect by the ceiling plate and the flow regulating effect by the sidewalls, a uniform gas flow along the substrate (parallel to the substrate surface) can be produced above the substrate to enable generation of a uniform film on the substrate.

In this method, the ceiling plate and the sidewalls may be provided such that all of the bottom surface of the ceiling plate, an opening surface of the nozzle, and the substrate holding surface are parallel.

With this configuration, a film with even better in-plane uniformity of film thickness distribution can be formed.

In this method, the ceiling plate may be provided such that the difference I [cm] in height position between the substrate holding surface of the substrate holder and the bottom surface of the ceiling plate is 0.15 cm or more and 6.05 cm or less.

With this configuration, a film with even better in-plane uniformity of film thickness distribution can be formed.

In this method, the sidewalls may be provided such that the J [cm] is 5.0 cm or less.

With this configuration, a film with even better in-plane uniformity of film thickness distribution can be formed.

In this method, the ceiling plate may be provided such that when the bottom surface of the ceiling plate has an area of B [cm²], B≥40 holds.

With this configuration, a film with even better in-plane uniformity of film thickness distribution can be formed.

In this method, the ceiling plate may be provided such that when a surface to be processed of the substrate has an area of A [cm²] and the bottom surface of the ceiling plate has an area of B [cm²], B/A≥0.5 holds.

With this configuration, a film with even better in-plane uniformity of film thickness distribution can be formed.

In this method, the sidewalls may be provided such that when surfaces of the sidewalls on the substrate holder side have an area of C [cm²], C≥20 holds.

With this configuration, a film with even better in-plane uniformity of film thickness distribution can be formed.

In this method, the sidewalls may be provided such that when a surface to be processed of the substrate has an area of A [cm²] and facing surfaces of the sidewalls have an area of C [cm²], C/A≥0.2 holds.

With this configuration, a film with even better in-plane uniformity of film thickness distribution can be formed.

This film forming method may further comprise an exhaust step of discharging an exhaust gas from the film forming unit.

With this configuration, a film with further better in-plane uniformity of film thickness distribution can be formed.

In this method, when the carrier gas supplied from the nozzle has a flow rate of Q [L/minute] and the exhaust gas has a flow rate of E [L/minute], E/Q may be set to 5.0 or less.

With this configuration, a film with further better in-plane uniformity of film thickness distribution can be formed.

In this method, the substrate may be moved below the nozzle.

With this configuration, a film having a large area with good in-plane uniformity of film thickness distribution can be formed.

In this method, a solution containing gallium may be used as the raw material solution.

With this configuration, a gallium oxide film with good in-plane uniformity of film thickness distribution can be formed.

In this method, a solution containing halogen may be used as the raw material solution.

With this configuration, a crystalline oxide film with good in-plane uniformity of film thickness distribution can be formed.

In this method, a substrate with a surface to be processed having an area of 50 cm² or more or a diameter of 4 inches (100 mm) or more may be used as the substrate.

With this configuration, a film having a large area with good in-plane uniformity of film thickness distribution can be formed.

The present invention was made to achieve the above object and provides an oxide semiconductor film comprising gallium as a main component, wherein the oxide semiconductor film has an area of 70 cm² or more or a surface size of 4 inches (100 mm) or more in diameter, and the oxide semiconductor film has a film thickness with an in-plane distribution of less than ±5%.

Such an oxide semiconductor film can be suitably used for semiconductor devices, for example, in that the yield of fabricated semiconductor devices is high and the number of semiconductor device fabrication steps involving a polishing step can be reduced.

In this oxide semiconductor film, the oxide semiconductor film may have a corundum structure.

This configuration is more suitable for semiconductor devices.

The present invention was made to achieve the above object and provides a laminate of an oxide semiconductor film and a substrate, the oxide semiconductor film comprising gallium as a main component, wherein the oxide semiconductor film of the laminate has an area of 70 cm² or more or a surface size of 4 inches (100 mm) or more in diameter, and the oxide semiconductor film has a film thickness with an in-plane distribution of less than ±5%.

Such a laminate can be suitably used for semiconductor devices, for example, in that the yield of fabricated semiconductor devices is high and the number of semiconductor device fabrication steps involving a polishing step can be reduced.

In this laminate, the oxide semiconductor film may have a corundum structure.

This configuration is more suitable for semiconductor devices.

### ADVANTAGEOUS EFFECTS OF INVENTION

As described above, in the film forming apparatus of the present invention, the film forming apparatus has a simple structure and can form a film with good in-plane uniformity of film thickness distribution on a substrate by using a raw material solution in the form of a mist. Further, in the film forming method of the present invention, a film with good in-plane uniformity of film thickness distribution can be formed on a substrate by using a raw material solution in the form of a mist by a simple method. In addition, the oxide semiconductor film and the laminate of the present invention can be suitably used for semiconductor devices, for example, in that the yield of fabricated semiconductor devices is high and the number of semiconductor device fabrication steps involving a polishing step can be reduced.

### BRIEF DESCRIPTION OF DRAWINGS

FIG. 1 is a schematic configuration diagram illustrating an example of a film forming apparatus of the present invention;
FIG. 2 is an illustration of an example of an atomizer according to the present invention;
FIG. 3 is an illustration of an example of a film forming chamber according to the present invention;
FIG. 4 is an illustration of an example of a nozzle according to the present invention;
FIG. 5 is an illustration of an example with a plurality of nozzles;
FIG. 6 is an illustration of an example of the nozzle with a plurality of nozzle opening surfaces;
FIG. 7 is an illustration of an example of a film forming unit according to the present invention;
FIG. 8 is an illustration of an example of the film forming unit according to the present invention;
FIG. 9 is an illustration of an example of the film forming unit according to the present invention;
FIG. 10 is an illustration of an example of the film forming unit according to the present invention;
FIG. 11 is an illustration of an example of the film forming unit according to the present invention;
FIG. 12 is a diagram illustrating an example of sidewalls according to the present invention;
FIG. 13 is an illustration of an example of a moving mechanism that reciprocates below the nozzle;
FIG. 14 is an illustration of an example of the moving mechanism that rotationally moves in one direction below the nozzle;
FIG. 15 is an illustration of an example of the film forming unit with an exhaust unit according to the present invention;
FIG. 16 is an illustration of an example of the exhaust unit according to the present invention;
FIG. 17 is a schematic configuration diagram illustrating a film forming apparatus used in Example 1 and the like;
FIG. 18 is a diagram illustrating the inside of a film forming chamber of the film forming apparatus in FIG. 17 as viewed from the side in FIG. 17;
FIG. 19 is a schematic configuration diagram illustrating a film forming apparatus used in Example 2;
FIG. 20 is a schematic configuration diagram illustrating a film forming apparatus used in Comparative Example 1;
FIG. 21 is a schematic configuration diagram illustrating a film forming apparatus used in Comparative Example 2;
FIG. 22 is a schematic configuration diagram illustrating a film forming unit used in Example 6;
FIG. 23 is a chart illustrating the results of Examples and Comparative Examples;
FIG. 24 is an illustration of an example of mist flow in a film forming unit 140; and
FIG. 25 is an illustration of an inside section of the sidewalls in FIG. 24.

### DESCRIPTION OF EMBODIMENTS

Hereinafter, the present invention will be described in detail. However, the present invention is not limited thereto.

As described above, there has been a demand for an oxide semiconductor film with good in-plane uniformity of film thickness distribution and a laminate, as well as a film forming apparatus and a film forming method capable of forming such a film by the mist CVD method.

The inventors of the present invention have conducted elaborate studies on the above problem and conceived a film forming apparatus comprising: an atomizer configured to atomize a raw material solution to generate a mist; a carrier gas supplier configured to supply a carrier gas that conveys the mist generated by the atomizer; and a film forming unit configured to heat the mist conveyed by the carrier gas to form a film, wherein the film forming unit includes a substrate holder configured to hold the substrate, a nozzle located above the substrate holder and configured to supply the mist onto the substrate, a ceiling plate located above the substrate holder and configured to regulate a flow of the mist supplied from the nozzle, and sidewalls facing each other with the substrate holder interposed, and when a difference in height position between a substrate holding surface of the substrate holder and a bottom surface of the ceiling plate is I [cm] and a shortest distance between a substrate holding region of the substrate holder and each of the sidewalls is J [cm], IJ≤15 holds. The inventors have found that this film forming apparatus having a simple structure can form a film with good in-plane uniformity of film thickness distribution on a substrate by using a raw material solution in the form of a mist. This finding has led to completion of the invention.

The inventors of the present invention have conducted elaborate studies on the above problem and conceived a film forming method in which a film is formed on a substrate by heating a mist of a raw material solution, the film forming method comprising: a mist generating step of atomizing the raw material solution to generate a mist; a mist conveying step of conveying the mist to a film forming unit; and a film forming step of forming a film by supplying the mist onto the substrate placed on a substrate holder in the film forming unit from a nozzle located above the substrate holder, and heating the mist, wherein in the film forming step, the mist is supplied from the nozzle into a space surrounded by a ceiling plate provided above the substrate holder and by sidewalls facing each other with the substrate holder interposed, wherein a difference in height position between a substrate holding surface of the substrate holder and a bottom surface of the ceiling plate is I [cm], and a shortest distance between a substrate holding region of the substrate holder and each of the sidewalls is J [cm], wherein the ceiling plate and the sidewalls are provided such that IJ≤15 holds. The inventors have found that this film forming method can form a film with good in-plane uniformity of film thickness distribution on a substrate by using a raw material solution in the form of a mist by a simple method. This finding has led to completion of the invention.

The inventors of the present invention have conducted elaborate studies on the above problem and conceived: an oxide semiconductor film comprising gallium as a main component, wherein the oxide semiconductor film has an area of 70 cm² or more or a surface size of 4 inches (100 mm) or more in diameter, and the oxide semiconductor film has a film thickness with an in-plane distribution of less than ±5%; and a laminate of an oxide semiconductor film comprising gallium as a main component and a substrate, wherein the oxide semiconductor film of the laminate has an area of 70 cm² or more or a surface size of 4 inches (100 mm) or more in diameter, and the oxide semiconductor film has a film thickness with an in-plane distribution of less than ±5%. The inventors have found that these oxide semiconductor film and laminate can be suitably used for semiconductor devices, for example, in that the yield of fabricated semiconductor devices is high and the number of semiconductor device fabrication steps involving a polishing step can be reduced.

Hereinafter, a description will be given with reference to the drawings.

### Oxide Semiconductor Film

An oxide semiconductor film according to the present invention is characterized by containing gallium as a main component, having an area of 70 cm² or more or a surface size of 4 inches (100 mm) or more in diameter, and having a film thickness with an in-plane distribution of less than ±5%. The upper limit is not limited because a larger area or diameter of the film results in a large area. However, an example of the upper limit can be an area of 750 cm² or a diameter of 300 mm. An oxide semiconductor film is typically composed of a metal and oxygen. In the oxide semiconductor film according to the present invention, the metal contains gallium as a main component. As used herein the main component means that 50 to 100% of a metal component is gallium. The metal component other than gallium may include, for example, one or two or more metals selected from iron, indium, aluminum, vanadium, titanium, chromium, rhodium, iridium, nickel and cobalt.

The in-plane distribution of film thickness is less than ±5% and even more preferably less than ±3%. Here, the in-plane distribution of film thickness referred to in the present invention is obtained by measuring nine or more points in a plane and calculating: film thickness distribution [±%]=(maximum film thickness-minimum film thickness)/((average film thickness) × 2) × 100.

The film thickness can be measured by a step-type film thickness measuring system, an optical interferometry film thickness measuring system, or the like. However, the measuring method is not limited as long as the film thickness at each point can be measured.

Possible reasons for deterioration (increase) of in-plane distribution of film thickness in conventional film forming apparatuses and film forming methods include mist supply method, the amount of supply, nonuniformity in amount of mist supply due to the structure surrounding the substrate, and temperature distribution produced in the substrate. As a result of elaborate studies and try and error, the inventors of the present invention have conceived that an appropriate structure surrounding the substrate, as in a film forming apparatus described later, can make the amount of supply uniform and achieve good in-plane uniformity of film thickness distribution, and successfully produced a film with good uniformity in in-plane distribution of film thickness as described above for the first time.

The oxide semiconductor film according to the present invention can contain a dopant depending on the intended use. The dopant is not limited. Examples include n-type dopants such as tin, germanium, silicon, titanium, zirconium, vanadium, and niobium, or p-type dopants such as copper, silver, tin, iridium, and rhodium. The concentration of the dopant may be, for example, about 1.0×10¹⁶ to 1.0×10²²/cm³, may be a low concentration of about 1.0×10¹⁷/cm³ or lower, or a high concentration of about 1.0×10²⁰/cm³ or higher.

In the oxide semiconductor film according to the present invention, the film thickness is not limited. For example, the film thickness may be 0.05 to 100 µm, preferably 0.1 to 50 µm, and more preferably 0.5 to 20 µm.

### Laminate

A laminate according to the present invention is characterized by including an oxide semiconductor film containing gallium as a main component with an area of 70 cm² or more or a surface size of 4 inches (100 mm) or more in diameter on a substrate.

Another layer may be interposed between the substrate and the oxide semiconductor film. As used herein another layer means a layer having a composition different from those of the substrate and the oxide semiconductor film on the outermost surface layer and, for example, may be any one of a crystalline oxide film, an insulating film, a metal film, and the like.

The oxide semiconductor film and the laminate according to the present invention can be used for semiconductor devices by performing structural design as appropriate. For example, a semiconductor layer can be formed in each of a Schottky barrier diode (SBD), a metal semiconductor field effect transistor (MESFET), a high electron mobility transistor (HEMT), a metal oxide semiconductor field effect transistor (MOSFET), an electrostatic induction transistor (SIT), a junction field effect transistor (JFET), an insulated gate bipolar transistor (IGBT), a light emitting diode (LED), and the like.

The oxide semiconductor film and the laminate according to the present invention can be obtained by performing film formation using the film forming apparatus according to the present invention described later. Such a film forming apparatus and film forming method according to the present invention will be described.

Here, a mist referred to in the present invention refers to a generic term of liquid fine particles dispersed in a gas and includes those called fog and droplets.

### Film Forming Apparatus

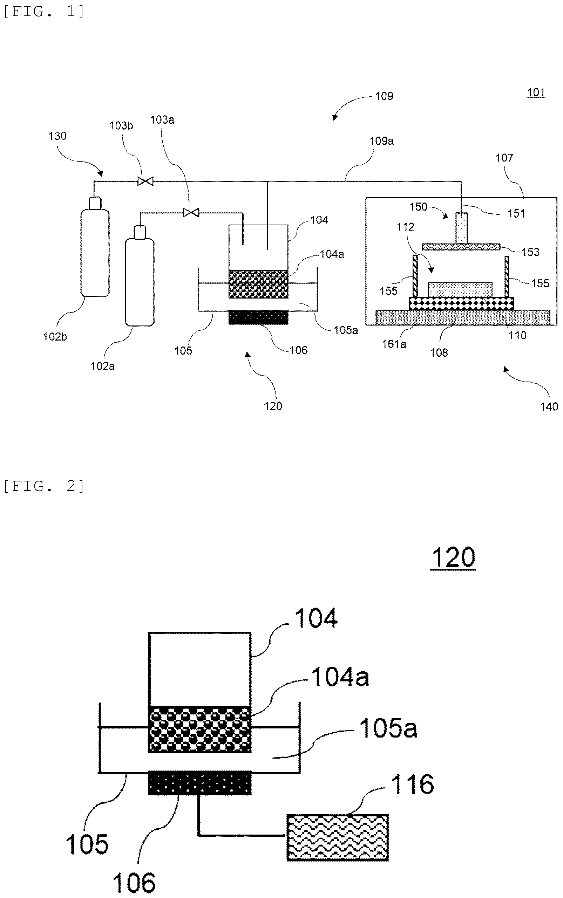

First, the film forming apparatus according to the present invention will be described. FIG. 1 illustrates an example of a film forming apparatus 101 according to the present invention. The film forming apparatus 101 at least includes an atomizer 120 configured to atomize a raw material solution to generate a mist, a carrier gas supplier 130 configured to supply a carrier gas that conveys the mist, a film forming unit 140 configured to heat the mist to form a film on a substrate, and a conveyor 109 connecting the atomizer 120 and the film forming unit 140 to convey the mist using the carrier gas. The film forming apparatus 101 may include an exhaust unit configured to discharge an exhaust gas from a film forming chamber 107. The film forming apparatus 101 may further include a controller (not illustrated) configured to control the whole or a part of the film forming apparatus 101 so that its operation is controlled.

### (Atomizer)

The atomizer 120 atomizes a raw material solution to generate a mist. The atomizer is not limited as long as it can atomize a raw material solution and may be a known atomizer, but an atomizer using ultrasonic vibration is preferred. This is because if so, more stable atomization can be achieved.

An example of such an atomizer 120 is illustrated in FIG. 2. For example, the atomizer 120 may include a mist generation source 104 that accommodates a raw material solution 104a, a container 105 that stores a medium that can transmit ultrasonic vibration, such as water 105a, and an ultrasonic transducer 106 attached to the bottom surface of the container 105. To be specific, the mist generation source 104 including a container that accommodates the raw material solution 104a is stored in the container 105 storing water 105a, using a support (not illustrated). The container 105 is equipped with the ultrasonic transducer 106 at the bottom, and the ultrasonic transducer 106 is connected to a vibrator 116. When the vibrator 116 is activated, the ultrasonic transducer 106 vibrates, and ultrasound propagates into the mist generation source 104 through water 105a to atomize the raw material solution 104a.

### (Carrier Gas Supplier)

The carrier gas supplier 130 has a carrier gas source 102a that supplies a carrier gas (main carrier gas) and may include a flow control valve 103a for adjusting the flow rate of the main carrier gas fed from the carrier gas source 102a. The carrier gas supplier 130 may also include, if necessary, a diluting carrier gas source 102b that supplies a carrier gas for dilution (diluting carrier gas) and a flow control valve 103b for adjusting the flow rate of the diluting carrier gas fed from the diluting carrier gas source 102b.

The carrier gas is not limited to any particular kind and may be selected as appropriate according to a formed product. Examples include oxygen, ozone, inert gas such as nitrogen and argon, and reducing gas such as hydrogen gas and forming gas. One kind or two or more kinds of carrier gas may be employed. For example, a diluent gas obtained by diluting the same gas as a first carrier gas with another gas (for example, diluting 10 times) may be further used as a second carrier gas, or air may be used. The carrier gas may be supplied at one place or may be at two or more places.

### (Film Forming Unit)

The film forming unit 140 heats a mist to cause a thermal reaction and forms a film on a surface of a substrate 110. The film forming unit 140 may have such a structure that a part or the whole of the film forming unit 140 is surrounded. For example, as illustrated in FIG. 1, the film forming unit 140 may include a film forming chamber 107 that accommodates a substrate holder 112, a nozzle 150, a ceiling plate 153, and sidewalls 155 inside and surrounds the entire film forming unit 140. Such a structure can reduce impurities in a film to be formed. The film forming chamber 107 is not limited to the shape that provides a complete surrounding and may have a shape that has a gap and only partially surrounds the film forming unit. The film forming unit 140 is equipped with the substrate holder 112 to hold the substrate. The film forming unit 140 may include a substrate pedestal (susceptor), such as a hot plate 108, having the substrate 110 placed thereon for heating the substrate 110. The hot plate 108 may be provided inside the film forming chamber 107 as illustrated in FIG. 1 or may be provided outside the film forming chamber 107. The film forming chamber may not necessarily be provided. In this case, the structure of the film forming apparatus is extremely simple.

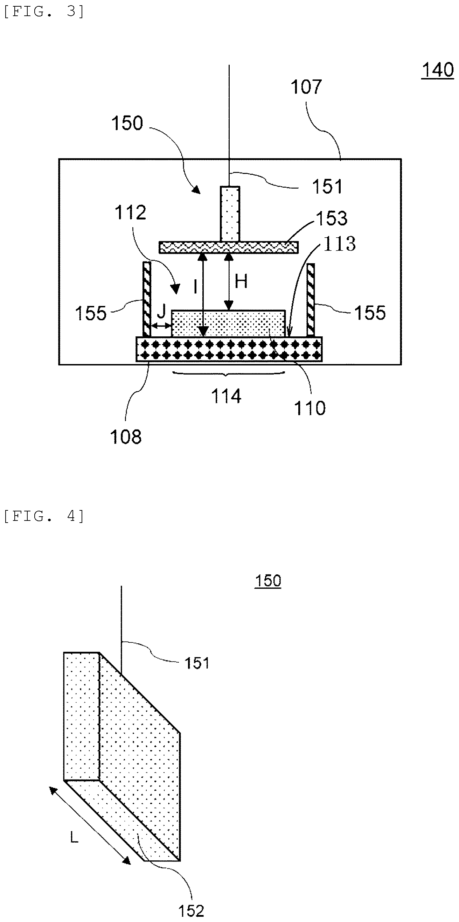

Further, as illustrated in FIG. 3, the film forming unit 140 is equipped with: the nozzle 150 above the substrate holder 112 for supplying a mist to the substrate 110 inside the film forming chamber 107; and the ceiling plate 153 and the sidewalls 155 for regulating a flow of mist supplied from the nozzle 150. In other words, a mist supplied from the nozzle 150 onto the substrate 110 passes through a space surrounded by the ceiling plate 153, the sidewalls 155, and a substrate holding surface 113 of the substrate holder 112 to become a regulated flow that flows to a direction to the outside of the substrate. The flow rate and direction of the mist is thus homogenized. The outside of the substrate refers to a region excluding a space formed by a substrate surface in a direction normal to the surface.

### (Ceiling Plate)

The ceiling plate in the present invention is a member having a surface that intersects the normal to the substrate holding surface 113 of the substrate holder 112. As illustrated in FIG. 3, the ceiling plate 153 is not limited as long as it is installed above the substrate holder 112, and the shape, size, installation position, installation height, installation method, material, and number thereof are not limited as long as the requirements specified by the present invention are satisfied. For example, in the case of having the film forming chamber 107, the ceiling plate 153 can be provided between the ceiling of the film forming chamber 107 and the substrate 110 on the substrate holder 112. With the arrangement of the ceiling plate 153, a flow of mist is less disturbed by a flow of ambient gas due to thermal convection in a film forming step by heating, and the flow of mist supplied from the nozzle 150 is regulated and supplied onto the substrate 110 to form a film with excellent in-plane uniformity of film thickness distribution.

As described above, the ceiling plate 153 is disposed at any position above the substrate holder 112, but, for example, as illustrated in FIG. 3, may be disposed vertically above the upper surface of the hot plate 108 on which the substrate 110 is placed. Such arrangement is simple and enables a film with sufficiently excellent film thickness uniformity to be formed on the substrate.

Possible shapes of the ceiling plate are polygon, semi-circle, circle, and oval, but quadrangle is preferred. This is because if so, the symmetry is good and the in-plane uniformity of film thickness distribution of the formed film is stably good.

The ceiling plate may be in contact with a side surface of the nozzle or a gap may be provided. For example, the ceiling plate may have a hole (in other words, donut shape), and the nozzle may be inserted into this hole. In this case, the gap between the ceiling plate and the side surface of the nozzle may be 2 cm or less, preferably 1 cm or less, and more preferably 0 cm. This is because if so, a film with stably good in-plane uniformity of film thickness distribution can be obtained.

The distance between the ceiling plate and the nozzle opening surface 152 (see FIGS. 4 to 6) is 0 cm when the nozzle and the ceiling plate are integrated. When they are separate, the distance may have a value obtained by subtracting the wall thickness of the nozzle from the shortest distance between the ceiling plate and the nozzle opening surface. For example, when the distance between the ceiling plate and the nozzle opening surface is 2.5 cm and the wall thickness of the nozzle included in the shortest distance is 0.5 cm, the shortest distance between the ceiling plate and the nozzle opening surface is 2.0 cm.

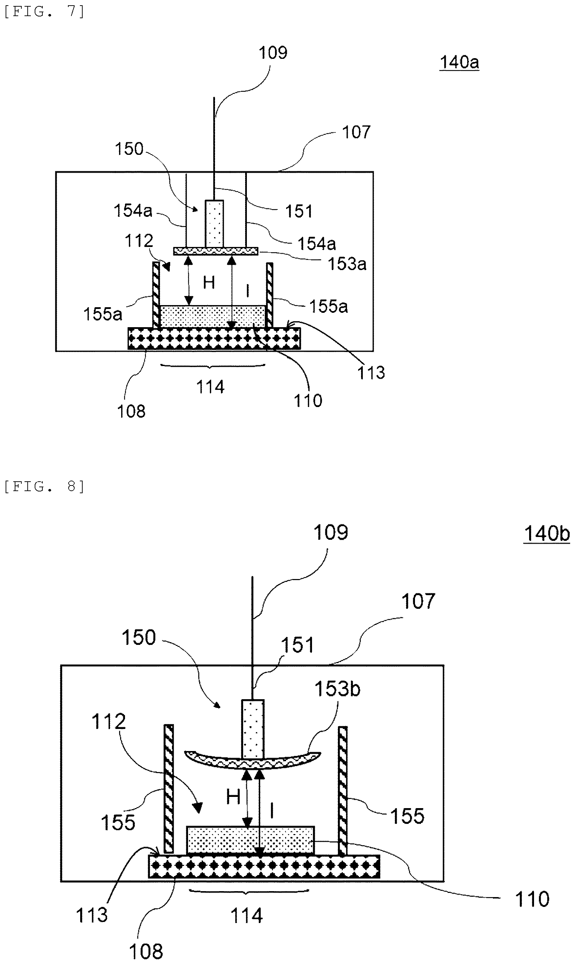

Further, the ceiling plate may be suspended from the film forming chamber by using a fixture 154a or the like, like a ceiling plate 153a in a film forming unit 140a illustrated in FIG. 7, but preferably the ceiling plate is fixed to a side surface of the nozzle as illustrated in FIG. 3. This is because if so, the formed film has stably good in-plane uniformity of film thickness distribution.

A part or the whole of the ceiling plate may be curved to facilitate a flow of mist in a particular direction, like a ceiling plate 153b in a film forming unit 140b illustrated in FIG. 8, or may be flexed, or may be formed into a curved surface (that is, a domed shape) integrated with the sidewalls as will be described later. However, preferably, the ceiling plate is installed parallel to the substrate holder 112 as illustrated in FIG. 3. More specifically, it is preferable that the ceiling plate 153 is installed such that the substrate holding surface 113 of the substrate holder 112 and the bottom surface of the ceiling plate 153 are parallel to each other. This is because if so, the formed film has stably good in-plane uniformity of film thickness distribution.

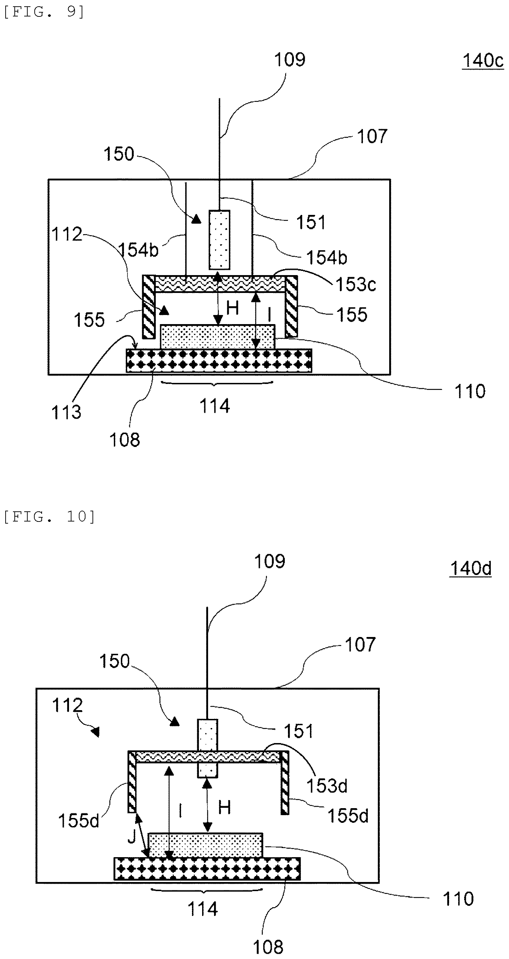

The ceiling plate may be installed in the same plane as the opening surface of the nozzle, may be closer to the substrate 110 than the opening surface of the nozzle 150, like a ceiling plate 153c suspended by a fixture 154b in a film forming unit 140c illustrated in FIG. 9, or may be more distant from the substrate 110 than the opening surface of the nozzle 150, like a ceiling plate 153d in a film forming unit 140d illustrated in FIG. 10. However, it is more preferable that the ceiling plate is installed in the same plane as the opening surface of the nozzle 150. This is because if so, the formed film has even better in-plane uniformity of film thickness distribution.

The film forming unit 140 may be equipped with a position adjustment mechanism (not illustrated) so that the difference in height position H [cm] between the nozzle opening surface 152 and the substrate 110 and/or the difference in height position I [cm] between the ceiling plate 153 and the substrate holding surface 113 can be adjusted as appropriate.

The thickness of the ceiling plate is not limited but preferably 2 mm or more. This is because if so, deformation by heating during film formation is suppressed.

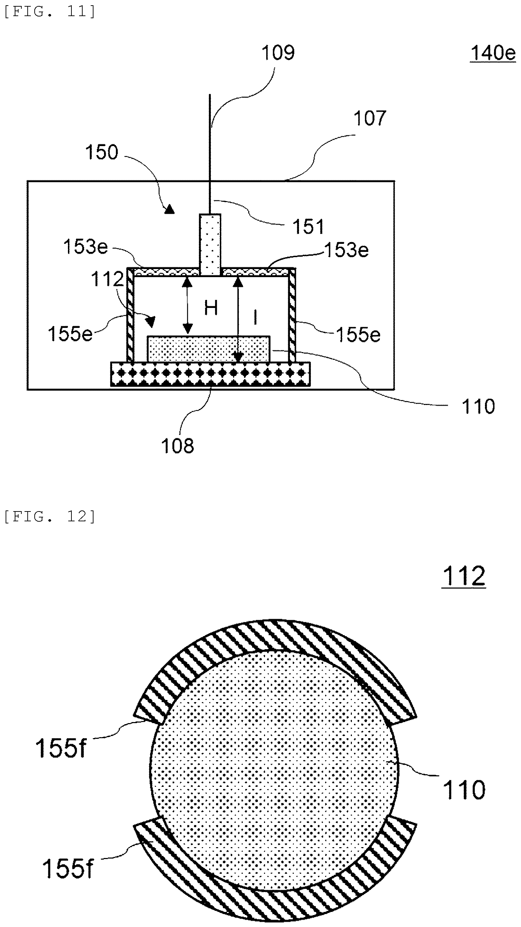

The number of ceiling plates is not limited. As illustrated in FIG. 3, one ceiling plate may be provided for one nozzle. Alternatively, like a film forming unit 140e illustrated in FIG. 11, a plurality of ceiling plates (here, left and right, two ceiling plates 153e) may be provided for one nozzle.

The material of the ceiling plate is not limited. Possible examples of the material include polysulfone, polyethersulfone, polyphenylene sulfide, polyetheretherketone, polyimide, polyetherimide, fluororesin, metals such as iron, aluminum, stainless steel, and gold, quartz, and glass.

The difference in height position (the shortest difference in height position) I [cm] between the bottom surface of the ceiling plate 153 and the substrate holding surface 113 of the substrate holder 112 is not limited as long as it is larger than the thickness of the substrate, but can be 0.15 cm or more and 6.05 cm or less (0.15 cm ≤ I ≤ 6.05 cm), preferably 0.50 cm or more and 3.00 cm or less (0.50 cm ≤ I ≤ 3.00 cm), and more preferably 1.00 cm or more and 2.00 cm or less (1.00 cm ≤ I ≤ 2.00 cm). This is because if so, the formed film has further better in-plane uniformity of film thickness distribution. In a spherical structure (domed shape) in which the ceiling plate and the sidewalls are integrated as described above, I is the shortest distance in a direction normal to the substrate holding surface between a substrate holding region of the substrate holding surface and the spherical surface. In the case of a curved shape of the ceiling plate as illustrated in FIG. 8, I is the shortest distance between the bottom surface of the ceiling plate and the substrate holding surface.

When the area of the bottom surface of the ceiling plate (when a plurality of ceiling plates are provided, their total area) is B [cm²], and the area of the substrate 110 is A [cm²], B/A≥0.5 is preferred. More preferably, B/A is 1 or more. When B/A≥0.5, a film with better in-plane uniformity of film thickness distribution is obtained. Further, B is preferably 40 or more (B≥40). In these numeral ranges, a film with more excellent in-plane uniformity of film thickness distribution is formed. The upper limits of B/A and B are not limited. This is because if the upper limits are greater than the above numerical values, the flow regulating effect by the ceiling plate is fulfilled stably. However, B/A is preferably 100 or less. This is to suppress unnecessary size increase of the apparatus. An example of the upper limit of B can be 3000 cm². This is to suppress unnecessary size increase of the apparatus.

### (Sidewall)

In the present invention, the sidewall is a member having a surface intersecting at least one of a plane including the substrate holding surface 113 of the substrate holder 112 or a plane including the bottom surface of the ceiling plate (the surface facing the substrate holding surface 113). In the film forming unit 140, as illustrated in FIG. 3, the sidewalls 155 are provided to face each other with the substrate holder 112 interposed therebetween in order to suppress diffusion of a mist supplied from the nozzle 150 to the side without being supplied onto the substrate.

As illustrated in FIG. 3, as long as the sidewalls 155 are provided so as to sandwich the substrate holder 112, the shape, size, installation position, installation height, installation method, material, and number thereof are not limited. For example, in the case of having the film forming chamber 107, the sidewalls 155 each can be provided between a side surface wall of the film forming chamber 107 and the substrate holder 112. Instead of installing the sidewalls 155, the wall of the film forming chamber 107 may function as a sidewall according to the present invention. With the arrangement of the sidewalls 155 in this way, a mist supplied from the nozzle 150 can be prevented from mixing with an external gas and diffusing to the side without being supplied onto the substrate. As previously mentioned, because of the synergistic effect of the sidewalls 155 and the ceiling plate 153, a flow of mist supplied from the nozzle 150 is regulated and supplied onto the substrate 110 to form a film with excellent in-plane uniformity of film thickness distribution.

Here, the shortest distance between the substrate holding region 114 of the substrate holder 112 and each of the sidewalls 155 is defined as J [cm]. As illustrated in FIG. 3, when the sidewall 155 is in contact with the substrate holder 112, this shortest distance J [cm] corresponds to the distance between the sidewall 155 and the substrate holding region 114 in the substrate holding surface 113 of the substrate holder 112. As illustrated in FIG. 10, when a sidewall 155d is not in contact with the substrate holder 112, the shortest distance J [cm] corresponds to the shortest distance between the substrate holding region 114 and a lower end of the sidewall 155d.

In the present invention, IJ, which is the product of the aforementioned difference in height position I [cm] between the bottom surface of the ceiling plate 153 and the substrate holding surface 113 of the substrate holder 112 (for example, the shortest difference in height position), can be IJ=0 as long as IJ≤15, but preferably IJ≤12, more preferably 1 or more and 9 or less (1≤IJ≤9). If IJ>15, a flow of mist is disturbed due to an incoming flow of ambient gas, diffusion of mist, and thermal convection, resulting in a film with poor in-plane uniformity of film thickness distribution.

The shortest distance J [cm] is not limited as long as IJ≤15, but preferably 10 cm or less (J≤10), may be 0 cm (in other words, in contact) as illustrated in the sidewall 155a in FIG. 7, more preferably 5.0 cm or less, and more preferably 0.5 cm or more. When J is within such a range, the amount of mist supply to an end portion of the substrate 110 is stable and sufficient. It is also possible to suppress the effect of reduced amount of mist supply due to friction between the carrier gas containing the mist and the sidewall 155 when J is small. For example, respective J's for the left and right sidewalls in FIG. 3 may be different from each other as long as IJ≤15 is satisfied, but preferably equal to each other.

The height of the upper ends of the sidewalls is not limited. The height position may be set to be lower than the ceiling plate as illustrated in FIG. 3, or the height position may be set to be higher than the ceiling plate as illustrated in FIG. 8. Alternatively, as illustrated in FIG. 11, the height position may be the same.

The manner of installation of the sidewalls is not limited. The sidewalls may be installed on the hot plate 108 as illustrated in FIG. 3 or may be fixed to the ceiling plate 153c, 153d as illustrated in FIGS. 9 and 10. When the sidewalls are fixed to the ceiling plate, the height of the lower end portions of the sidewalls may be at a position lower than the surface of the substrate 110 on the substrate holder 112 as illustrated in FIG. 9, or may be at a higher position as illustrated in FIG. 10. When the sidewalls are fixed to the ceiling plate, a member in which a ceiling plate and sidewalls are integrated may be used.

There may be a gap between the sidewalls and the ceiling plate as illustrated in FIGS. 3, 7, and 8, or there may be no gap as illustrated in FIGS. 9 to 11. In any case, as long as IJ≤15, a film with good in-plane uniformity of film thickness distribution can be obtained. Possible shapes of the sidewalls are polygon, semi-circle, circle, and oval, but quadrangle is preferred. This is because if so, the symmetry is good and the formed film has stably good in-plane uniformity of film thickness distribution.

A part or the whole of the sidewalls may be curved to facilitate a flow of mist in a particular direction, like sidewalls 155f in FIG. 12, or may be flexed, but preferably the sidewalls 155 are installed parallel as illustrated in FIG. 3. More specifically, it is preferable that the sidewalls 155 are installed to be parallel to each other and point-symmetric with respect to the center of the substrate holder 112. This is because if so, the formed film has good in-plane uniformity of film thickness distribution.

The thickness of the sidewalls is not limited but preferably 2 mm or more. This is because if so, deformation by heating during film formation is suppressed. The material of the sidewalls is not limited. Examples of the material may include polysulfone, polyethersulfone, polyphenylene sulfide, polyetheretherketone, polyimide, polyetherimide, fluororesin, metals such as iron, aluminum, stainless steel, and gold, quartz, and glass.

The number of sidewalls is provided such that the sidewalls are provided to face each other with the substrate holder 112 interposed therebetween. When two pairs of sidewalls are provided, it is preferable to provide a gap partially between the ceiling plate and the sidewalls as illustrated in FIGS. 3, 7, and 8. This is to prevent the supplied gas from remaining and disturbing a flow of mist.

Alternatively, a plurality of substrate holders may be provided in a row in the film forming unit, and the substrate holders may be sandwiched between a pair of sidewalls. Alternatively, a plurality of substrate holders may be provided in the film forming unit, and a plurality of (for example, three or more) sidewalls may be provided so as to face each other with the substrate holding region of each of the substrate holders interposed therebetween. In this case, the substrate holder can be set to be located between each sidewall of three or more sidewalls, for example. Furthermore, a manner in which these are combined may be employed. In other words, a plurality of substrate holders may be disposed in multiple rows and three or more sidewalls may be provided.

When the area of surfaces on the substrate holder side of the sidewalls (when a plurality of sidewalls are provided, their total area) is C [cm²], and the area of a surface to be processed of the substrate is A [cm²], C/A≥0.2 is preferred. More preferably, C/A is 0.5 or more. When C/A≥0.2, a film with good in-plane uniformity of film thickness distribution can be obtained. Further, C is preferably 20 or more (C≥20). In these numeral ranges, a film with more excellent in-plane uniformity of film thickness distribution can be formed. The upper limits of C/A and C are not limited. This is because if the upper limits are greater than the above numerical values, the flow regulating effect by the sidewalls is fulfilled. However, C/A is preferably 10 or less. This is to suppress unnecessary size increase of the apparatus. An example of the upper limit of C can be 2100 cm². This is to suppress unnecessary size increase of the apparatus.

The sidewall(s) and the ceiling plate(s) may be equipped with a temperature regulating mechanism (not illustrated) capable of adjusting the temperature of a surface facing the substrate holder 112. If the temperature of the surface is too high, evaporation of a mist is accelerated, so that the film thickness increases at a position away from the nozzle opening surface on the substrate. If the temperature is too low, evaporation of a mist is decelerated, so that the film thickness decreases at a place near the nozzle opening surface. It is preferable to control the temperature approximately to 40 to 120°C. The temperature regulating mechanism may perform heat exchange using a liquid or gas heating medium, or may apply the Peltier effect, or may employ heating by a ribbon heater or the like. A wide variety of known heating media can be used as the heating medium. For example, liquid heating media such as water, glycols, alcohols, and silicone oils, and gas heating media such as air, nitrogen, helium, or fluorocarbons are suitably used.

### (Nozzle)

An example of the nozzle 150 is illustrated in FIG. 4. The nozzle 150 includes a connection section 151 connecting the conveyor 109 and the nozzle 150 and a nozzle opening surface (which may be simply referred to as opening surface) 152 for ejecting a mist.

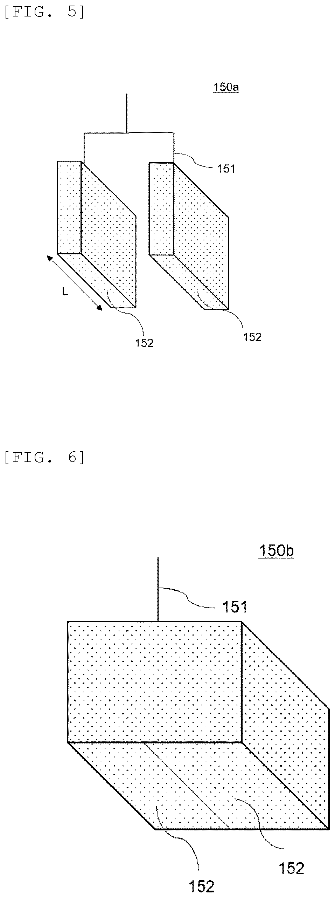

The number of nozzles and the number of opening surfaces may be any number equal to or greater than one. Like a nozzle 150a in FIG. 5, a plurality of nozzles may be provided, or like a nozzle 150b in FIG. 6, a plurality of opening surfaces may be provided.

Further, the angle formed between a plane including the nozzle opening surface 152 and a plane including substrate 110 is not limited. A nozzle having a nozzle opening surface inclined so as to facilitate a flow of mist in a particular direction may be provided. However, as illustrated in FIG. 3, it is preferable that the nozzle opening surface is provided parallel to the substrate holding surface 113 of the substrate holder 112 on which the substrate 110 is placed. This is because if so, a film with even better in-plane uniformity of film thickness distribution can be formed with a simpler structure. Furthermore, it is preferable that all of the bottom surface of the ceiling plate, the opening surface of the nozzle, and the substrate holding surface are parallel. This is because if so, a film with even better in-plane uniformity of film thickness distribution can be formed.

The film forming unit 140 may be equipped with a position adjustment mechanism (not illustrated) so that the difference in height position H [cm] between a point in the nozzle opening surface 152 of the nozzle and a surface of the substrate 110 can be adjusted as appropriate in a range as described later. The nozzle 150 may be constructed with a plurality of members, and the area S [cm²] of the opening surface of the nozzle can be adjusted as appropriate by size adjustment of the members.

Further, the nozzle 150 may be equipped with a temperature regulating mechanism (not illustrated) capable of adjusting the temperature of an outer surface of the nozzle 150 and the temperature of an inner surface of the nozzle 150. If the temperature of the inner and outer surfaces is too high, evaporation of a mist is accelerated, so that the film thickness increases at a position away from the nozzle opening surface on the substrate. If the temperature is too low, evaporation of a mist is decelerated, so that the film thickness decreases at a place near the nozzle opening surface. It is preferable to control the temperature approximately to 40 to 120°C. Since the distance from the hot plate 108 is changed by adjusting the H, the temperature of the nozzle 150 changes. Thus, it is preferable to have a temperature regulating mechanism different from the hot plate 108. The temperature regulating mechanism may perform heat exchange using a liquid or gas heating medium, for example, by providing piping around the nozzle 150, or may apply the Peltier effect, or may employ heating by a ribbon heater or the like. A wide variety of known heating media can be used as the heating medium. For example, liquid heating media such as water, glycols, alcohols, and silicone oils, and gas heating media such as air, nitrogen, helium, or fluorocarbons are suitably used.

Here, the area S of the nozzle opening surface 152 is preferably 0.1 or more and 400 or less. The difference in height position H between the nozzle opening surface 152 and the substrate 110 can be 0.1 or more and 6.0 or less, more preferably 0.2 or more and 3.0 or less. This is because if so, the formed film has further better in-plane uniformity of film thickness distribution.

When the area of the nozzle opening surface 152 is S [cm²] and the area of the substrate is A [cm²], S/A≤0.3 is preferable, and 0.004≤S/A≤0.15 is more preferable. If S/A≤0.3, a film with even better in-plane uniformity of film thickness distribution can be obtained. Here, the area A of the substrate is preferably 10 cm² or more and more preferably 50 cm² or more. The upper limit is not limited because a larger area or diameter of the film results in a large area, but an example of the upper limit can be an area of 750 cm² or a diameter of 300 mm.

The shape of the nozzle opening surface 152 is not limited. Possible shapes are polygon, circle, oval, and the like, but quadrangle is preferred and rectangle is more preferred. When the shape of the nozzle opening surface 152 is rectangular, and when the long-axis length of the nozzle opening surface 152 is L [cm] and the maximum length in the nozzle long-axis direction of the substrate is R [cm], L/R≥1 is preferable. This is because if L/R≥1, a film with good in-plane uniformity of film thickness distribution can be formed on a large-area substrate. The upper limit of L/R is not limited, but preferably 3 or less (L/R≤3), because with a larger L/R, the mist that is not supplied to the substrate increases.

### (Moving Mechanism)

As illustrated in FIG. 1, the film forming unit 140 can include a moving mechanism, such as a moving stage 161a, configured to move the substrate 110 below the nozzle 150. The direction of moving the substrate is not limited.

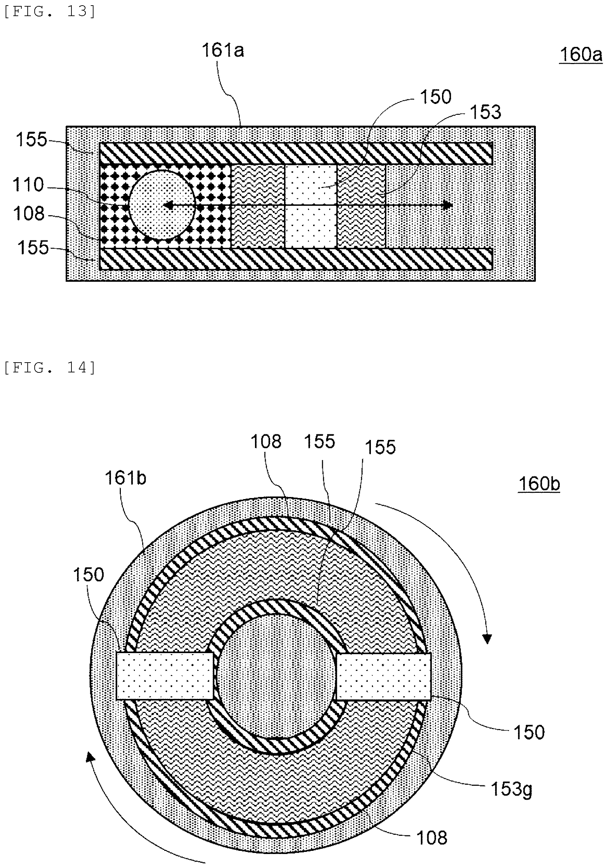

FIG. 13 and FIG. 14 illustrate the inside of the film forming unit with the moving mechanism as viewed from above the substrate holder. As an example, in a moving mechanism 160a as illustrated in FIG. 13, a moving stage 161a on which the substrate 110 and the hot plate 108 are placed is provided to allow the substrate 110 and the hot plate 108 to reciprocate below the nozzle 150. As another example, in a moving mechanism 160b as illustrated in FIG. 14, a moving stage 161b on which the substrate 110 and the hot plate 108 are placed allows the substrate 110 and the hot plate 108 to rotationally move below the nozzle 150. In this case, a mechanism for allowing the substrate to rotate on its axis may be provided so that the substrate rotates on its axis.

Further, a plurality of nozzles 150 may be disposed in the film forming unit 140 as illustrated in FIG. 14, a plurality of substrates 110 may be placed (the substrates 110 are not depicted because they are hidden under the ceiling plate 153), or a plurality of substrates may be installed in the film forming unit 140 in FIG. 13. Such a structure is more suitable for mass production since films can be formed on many substrates at once while maintaining the in-plane uniformity of film thickness.

When the moving mechanism 160 for the substrate is provided, the speed of moving the substrate and the moving range are not limited, but the number of times one substrate passes through below the nozzle can be 0.1 or more per minute, preferably 0.5 or more, more preferably 1 or more. The number of times of 0.1 or more can prevent an updraft caused by local mist evaporation from affecting the supply gas and reducing the flow regulating effect by the ceiling plate, thereby more reliably preventing reduction in uniformity of film thickness. The upper limit of the number of times is not limited, but can be 120 or less and preferably 60 or less, because if the number of times increases, the fixing of the substrate becomes unstable due to inertial force.

More specifically, in a case of the moving mechanism as illustrated in FIG. 13, when the substrate moving speed is v [mm/min] for the width D [mm] in which the substrate is moved, v/D [/min] can be 0.1 or more, preferably 0.5 or more and 120 or less, and more preferably 1 to 60. D is not limited and, for example, can be equal to or greater than the diameter [mm] of the substrate (100 or more when the substrate has a diameter of 4 inches), and the upper limit thereof is not limited. With a larger D, films can be formed on a large number of substrates per nozzle. However, the film formation rate per substrate is reduced. Thus, 1000 mm or less is preferable to limit the number of substrates subjected to film formation per nozzle in terms of higher productivity. Here, v is not limited and can be 10 mm/min or more and 30000 mm/min or less, preferably 30 mm/min or more and 12000 mm/min or less, and more preferably 60 mm/min or more and 6000 mm/min or less. In a case of the rotary moving mechanism as illustrated in FIG. 14, the moving speed can be 0.1 rpm or higher, preferably 0.5 to 120 rpm, and more preferably 1 to 60 rpm.

### (Exhaust Unit)

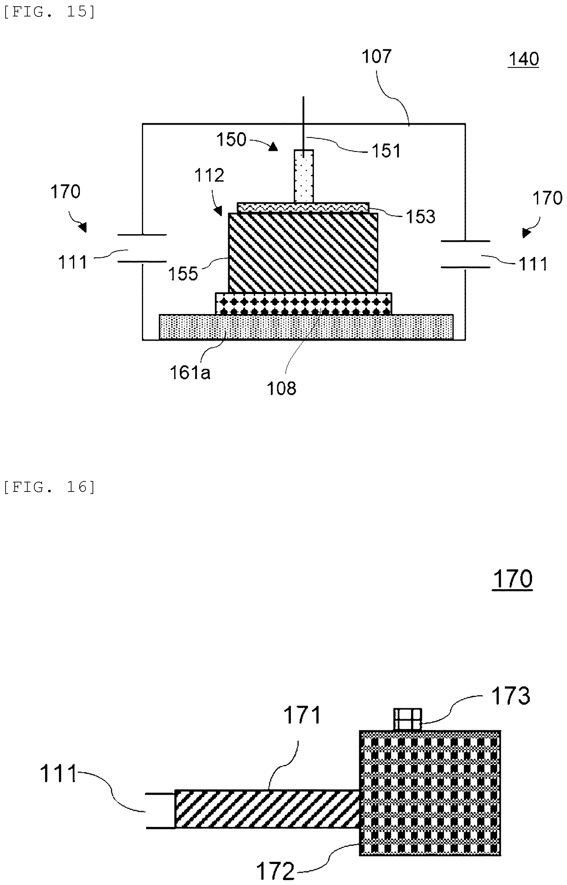

Further, as illustrated in FIG. 15, the film forming unit 140 may be equipped with an exhaust unit 170 for regulating a flow of a gas after the mist supplied together with the carrier gas onto the substrate 110 is used for film formation (also referred to as "exhaust gas" including a mist that is not used for film formation, a gas produced during film formation, a carrier gas, and the like) such that the exhaust gas flows to the outside of the substrate 110. The exhaust gas is discharged from the film forming unit 140 through the exhaust unit 170.

Due to the synergistic effect of the flow regulating effect by the ceiling plate and the sidewalls provided at positions as described above and convection produced by the supply of mist from the nozzle 150 and the exhaust gas discharged from the exhaust unit 170, a uniform flow of gas parallel to the surface of the substrate 110 is produced above the substrate 110 so that an even more uniform film can be formed on the substrate 110.

The exhaust unit 170 is not limited to any particular shape and configuration as long as it can discharge the exhaust gas from the film forming unit 140. For example, as illustrated in FIG. 15, exhaust ports 111 may be provided on the sides of the substrate 110 to perform forced exhaust. Such a configuration that allows the carrier gas and the like supplied from the nozzle 150 between the ceiling plate 153 and the substrate 110 to flow to the outside of the substrate 110 is particularly preferable.

The exhaust unit 170 may be the exhaust ports 111 themselves that are provided in the film forming unit 140 as described above, or a means for forced exhaust may be further added to the exhaust ports 111. An example of such an exhaust unit 170 is illustrated in FIG. 16. For example, an exhausting unit 172 provided outside the film forming chamber 107 forcedly discharges a gas in the film forming chamber 107 from the exhaust port 111 provided on a side surface of the film forming chamber 107, through an exhaust duct 171. The exhausting unit 172 is equipped with an exhaust flow control valve 173 for adjusting the flow rate of exhaust so that the flow rate of exhaust can be adjusted.

The shape of the exhaust port 111 may be circle, rectangle, or the like and is not limited. The exhaust unit 170 may be provided at one place or may be provided at two or more places as illustrated in FIG. 15. When provided at two or more places, the exhaust units 170 are preferably provided at symmetric locations with respect to the center of the nozzle opening surface. This is because if so, a film with even better in-plane uniformity of film thickness distribution can be stably formed.

Further, the exhaust unit 170 may include a temperature control mechanism (not illustrated) that controls the temperature of a part or the whole thereof in order to suppress deposition of a solid in the exhaust unit. Such a temperature control mechanism suppresses deposition of a solid in the exhaust unit 170 and facilitates control of the flow rate of exhaust. The temperature regulating mechanism may perform heat exchange using a liquid or gas heating medium, for example, by providing piping around the exhaust duct 171, or may apply the Peltier effect, or may employ heating by a ribbon heater or the like. A wide variety of known heating media can be used as the heating medium. For example, liquid heating media such as water, glycols, alcohols, and silicone oils, and gas heating media such as air, nitrogen, helium, or fluorocarbons are suitably used.

The material of a member that constitutes the exhaust unit 170 is not limited. Examples of the material may include polysulfone, polyethersulfone, polyphenylene sulfide, polyetheretherketone, polyimide, polyetherimide, fluororesin, metals such as iron, aluminum, stainless steel, and gold, quartz, and boron nitride. It is preferable that the member is made of boron nitride. This is because if so, an uneven flow of exhaust gas caused by rusting due to an unintended reaction with an unreacted raw material or deposition of a solid can be suppressed.

Furthermore, as previously mentioned, when the film forming chamber 107 includes the moving mechanism 160, for example, the exhaust port 111 may be provided on the moving mechanism 160 so that the exhaust port 111 (exhaust unit 170) is movable.

### (Conveyor)

The conveyor 109 connects the atomizer 120 and the film forming unit 140. The carrier gas conveys the mist through the conveyor 109 from the mist generation source 104 of the atomizer 120 to the nozzle 150 of the film forming unit 140. The conveyor 109 may be, for example, a supply tube 109a. For example, a quartz tube or a resin tube can be used as the supply tube 109a.

### (Raw Material Solution)

The raw material solution 104a is not limited as long as it contains a material that can be atomized, and may be either an inorganic material or an organic material. A solution (for example, aqueous solution) of a metal or a metal compound is suitably used as the raw material solution. A solution that contains one or two or more metals selected from gallium, iron, indium, aluminum, vanadium, titanium, chromium, rhodium, nickel, and cobalt can be used. In particular, a raw material solution containing gallium can form a gallium oxide film with good in-plane uniformity of film thickness distribution.

The raw material solution is not limited as long as the metal solution can be atomized, but a metal(s) in a complex or salt form dissolved or dispersed in an organic solvent or water can be suitably used as the raw material solution. Examples of the complex form include acetylacetonate complex, carbonyl complex, ammine complex, and hydride complex. Examples of the salt form include metal chloride salt, metal bromide salt, and metal iodide salt. A solution of the metal(s) dissolved in hydrobromic acid, hydrochloric acid, hydroiodic acid, or the like can be used as an aqueous solution of a salt. The solute concentration is preferably 0.01 to 1 mol/L.

The raw material solution may contain additives such as those containing halogen (for example, a hydrohalic acid) and oxidizer. A crystalline oxide film with good in-plane uniformity of film thickness distribution can be formed. Examples of the hydrohalic acid include hydrobromic acid, hydrochloric acid, and hydroiodic acid. Among those, hydrobromic acid or hydroiodic acid is preferred. Examples of the oxidizer include peroxides such as hydrogen peroxide (H₂O₂), sodium peroxide (Na₂O₂), barium peroxide (BaO₂), and benzoyl peroxide (C₆H₅CO)₂O₂, hypochlorous acid (HClO), perchloric acid, nitric acid, ozone water, and organic peroxides such as peracetic acid and nitrobenzene.

The raw material solution may further contain a dopant. The dopant is not limited. Examples include n-type dopants such as tin, germanium, silicon, titanium, zirconium, vanadium, and niobium, or p-type dopants such as copper, silver, tin, iridium, and rhodium. The concentration of the dopant may be, for example, about 1.0×10⁻⁹ to 1.0 mol/L, may be a low concentration of about 1.0×10⁻⁷ mol/L or lower, or a high concentration of about 0.01 mol/L or higher.

### (Substrate)

The substrate 110 is not limited as long as a film can be formed and supported thereon. The material of the substrate 110 is also not limited. A known substrate may be used, and either an organic compound or an inorganic compound may be used. Examples of the material may include polysulfone, polyethersulfone, polyphenylene sulfide, polyetheretherketone, polyimide, polyetherimide, fluororesin, metals such as iron, aluminum, stainless steel, and gold, quartz, glass, calcium carbonate, gallium oxide, zinc oxide, and the like. In addition, examples include monocrystalline substrates of silicon, sapphire or lithium niobate, lithium tantalate, SiC, GaN, iron oxide, chromium oxide, and the like. In the present invention, monocrystalline substrates as described above are preferable. With these substrates, a crystalline oxide film of higher quality can be obtained. In particular, a sapphire substrate, a lithium tantalate, and a lithium niobate substrate are relatively inexpensive and industrially advantageous. The thickness of the substrate is not limited but preferably 10 to 2000 µm and more preferably 50 to 800 µm.

A substrate with a surface subjected to film formation (a surface to be processed) having an area of 50 cm² or more or a diameter of 4 inches (100 mm) or more can be used and preferred because a film with good in-plane uniformity of film thickness distribution can be formed to a large area. The upper limit of the area or diameter of the substrate is not limited but, for example, the area may be 750 cm² or the diameter may be 300 mm.

### Film Forming Method

Hereinafter, referring to FIG. 1 again, an example of a film forming method according to the present invention will be described. The film forming method according to the present invention includes a mist generating step of atomizing a raw material solution to generate a mist; a mist conveying step of conveying the mist to a film forming unit; and a film forming step of forming a film by supplying the mist onto a substrate placed on a substrate holder in the film forming unit from a nozzle located above the substrate holder, and heating the mist. In the film forming method according to the present invention, by using a film forming apparatus set as described in the aforementioned film forming apparatus, a film with good in-substrate-plane uniformity of film thickness can be formed compared to a conventional method of performing film formation. In other words, the film forming method is characterized in that, in the film forming step, film formation is performed by supplying the mist from the nozzle into a space surrounded by a ceiling plate and sidewalls facing each other with the substrate holder interposed, wherein a difference in height position between a substrate holding surface of the substrate holder and a bottom surface of the ceiling plate is I [cm], and a shortest distance between a substrate holding region of the substrate holder and each of the sidewalls is J [cm], the ceiling plate and the sidewalls are provided such that IJ≤15 holds.

Details will be described. First, the raw material solution 104a is accommodated in the mist generation source 104 of the atomizer 120, the substrate 110 such as a crystalline substrate is placed on the hot plate 108, and the hot plate 108 is activated.

Next, the flow control valves 103a and 103b are opened to supply a main carrier gas from the carrier gas source 102a and a diluting carrier gas from the diluting carrier gas source 102b into the film forming chamber 107. The atmosphere in the film forming chamber 107 is sufficiently substituted with the carrier gases, and the flow rate of the main carrier gas and the flow rate of the diluting carrier gas are adjusted and controlled.

In the mist generating step, the ultrasonic transducer 106 is vibrated, and the vibration is propagated to the raw material solution 104a through the water 105a to atomize the raw material solution 104a to generate a mist.

Next, in the mist conveying step of conveying the mist carried by the carrier gas, the mist is conveyed by the carrier gas from the atomizer 120 to the film forming unit 140 through the conveyor 109 and introduced into the film forming chamber 107.

Then, in the film forming step, the mist is supplied from the nozzle 150 provided above the substrate holder 112 (the hot plate 108 on which the substrate 110 is placed) into a space surrounded by the ceiling plate 153, the sidewalls 155, and the substrate 110 in the film forming unit. The flow of the supplied mist is regulated by the ceiling plate and the sidewalls at predetermined positions, supplied onto the substrate 110, and heated by heat of the hot plate 108 in the film forming chamber 107 and thermally reacted, and forms a film on the substrate 110. Such a film forming method can form a film with good in-substrate-plane uniformity of film thickness, compared to the conventional method.

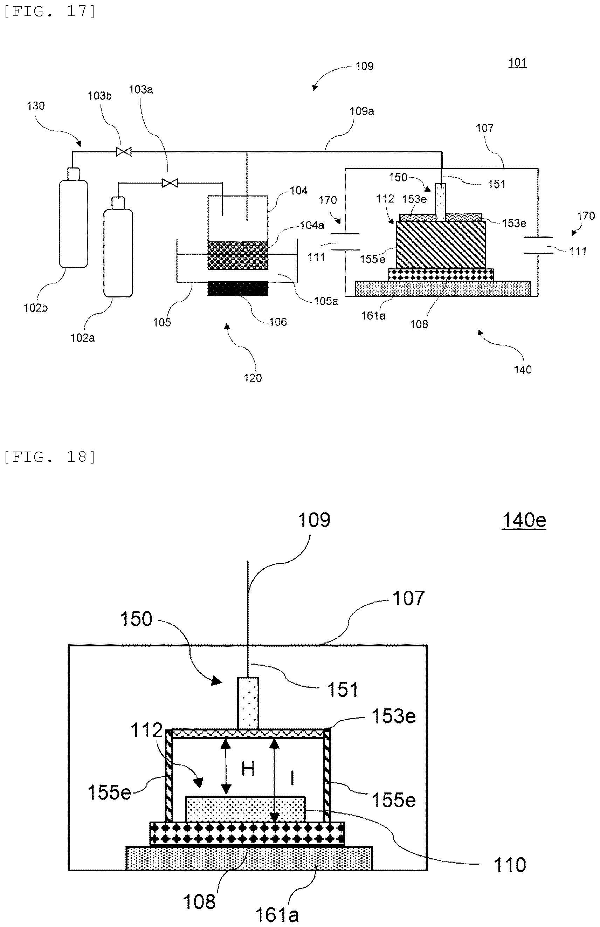

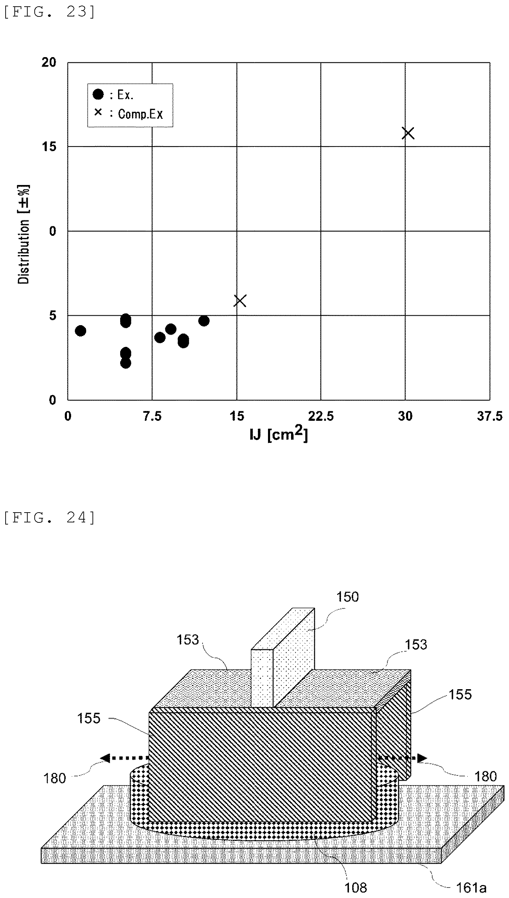

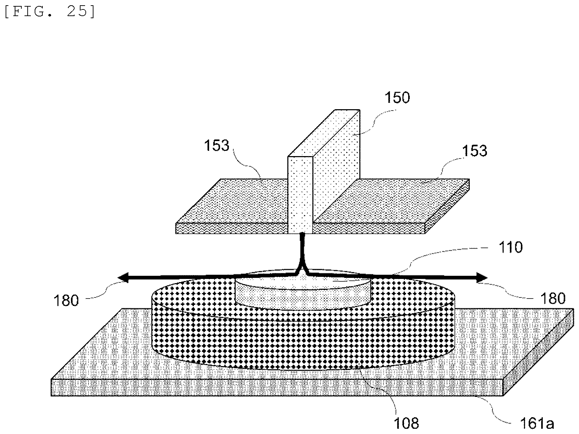

Referring to FIGS. 24 and 25, a flow of mist in the film forming unit 140 will be described in more detail. FIG. 25 illustrates the inside of the sidewalls in FIG. 24 (with the sidewalls removed). As illustrated in FIG. 25, a mist is supplied from the nozzle 150 from above the surface of the substrate 110 on the holder 112. Subsequently, while the ceiling plate 153 and the sidewalls 155 suppress disturbance of a mist flow by thermal convection by the hot plate 108 and an incoming external air flow, the mist flows in direction 180 and is naturally discharged from on the substrate 110. When forced exhaust is provided as illustrated in FIG. 17, while the exhaust unit 170 controls a flow of exhaust, the mist flows in direction 180 and the mist is forcedly discharged from on the substrate 110.

Film formation with the substrate 110 being moved below the nozzle 150 by the moving mechanism is effective in forming a large-area film and is also effective for forming an excellent film with a film thickness more uniform in plane.

The flow rate of the carrier gas is not limited. For example, when a film is formed on a substrate with a diameter of 4 inches (100 mm), 1 to 80 L/minute is preferable and 4 to 40 L/minute is more preferable. The flow rate Q of the carrier gas in the present invention is a measurement value at 20°C and normal pressure. When the flow rate is measured at other temperatures and pressures or a different kind of flow rate (for example, mass flow rate) is measured, the measurement value can be converted into a volume flow rate at 20°C and normal pressure by using an equation of state of gases.

The thermal reaction of the mist in the film forming unit 140 is not limited as long as the mist reacts by heating, and the reaction conditions and the like are also not limited. The conditions can be set as appropriate according to raw materials and formed products. For example, the heating temperature can be in the range of 120 to 600°C, preferably in the range of 200°C to 600°C, and more preferably in the range of 300°C to 550°C. When the heating temperature is T [°C], the area of the nozzle opening surface 152 is S [cm²], and the flow rate of the carrier gas is Q [L/minute], ST/Q is preferably 40 or more (ST/Q≥40) and more preferably 100 or more and 2000 or less (100≤ST/Q≤2000). When ST/Q≥40, the film has even better in-plane uniformity of film thickness distribution.

When the area of the nozzle opening surface 152 is S [cm²], the flow rate of the carrier gas is Q [L/minute], and the difference in height position between the nozzle opening surface 152 and the substrate 110 (for example, the longest distance of distances between points in the nozzle opening surface 152 and the surface of the substrate 110) is H [cm], SH/Q can be 0.015 or more and preferably 0.1 or more and 20 or less. When SH/Q≥0.015, the film has even better in-plane uniformity of film thickness distribution.

Here, the rate of the gas in a direction orthogonal to the substrate in the nozzle opening surface 152 can be 0.01 or more and 8.0 m/s or less and preferably 0.1 or more and 2.0 m/s or less. The rate of the gas in a direction orthogonal to the substrate in the nozzle opening surface 152 is the rate calculated by dividing the flow rate Q [L/minute] of the carrier gas at 20°C and normal pressure by the area S [cm²] of the nozzle opening surface 152 and converting the unit.

The thermal reaction may be performed in any atmosphere, such as in a vacuum, in a non-oxygen atmosphere, in a reducing gas atmosphere, in an air atmosphere, and in an oxygen atmosphere, and the atmosphere can be set as appropriate according to formed products. The reaction may be performed in any condition, such as under atmospheric pressure, under increased pressure, or under reduced pressure. Film formation under atmospheric pressure is preferable because the apparatus configuration can be simplified.

When an exhaust is discharged (exhaust step) in the film forming step, the flow rate of exhaust is not limited, but when the flow rate of the carrier gas supplied from the nozzle 150 is Q [L/minute] and the flow rate of the exhaust gas discharged from the exhaust unit 170 is E [L/minute], E/Q is preferably 5.0 or less and more preferably 0.5 or more and 3.0 or less. This is because if so, the film has even better in-plane uniformity of film thickness distribution. Here, E at which the exhaust is discharged from the exhaust unit 170 can be measured by using a flow meter at the exhaust port 111 at 20°C and normal pressure, or can be calculated by the product of a linear velocity measured by using an anemometer and the area of the opening surface of the exhaust port 111. When the flow rate is measured by using other methods, temperatures, and pressures, the measurement value can be converted into volume flow rate at 20°C and normal pressure by using an equation of state of gases.

In the present invention, an annealing process may be performed after film formation. The temperature of the annealing process is not limited but preferably 600°C or lower and more preferably 550°C or lower. This is because if so, the crystallinity of the film is not impaired. The processing time of the annealing process is not limited but preferably 10 seconds to 10 hours and more preferably 10 seconds to 1 hour.

Film formation may be performed directly on the substrate, or a film may be deposited on a middle layer formed on the substrate. The middle layer is not limited and, for example, can contain an oxide containing any one of aluminum, titanium, vanadium, chromium, iron, gallium, rhodium, indium, and iridium, as a main component. More specifically, examples include Al₂O₃, Ti₂O₃, V₂O₃, Cr₂O₃, Fe₂O₃, Ga₂O₃, Rh₂O₃, In₂O₃, and Ir₂O₃. When two elements selected from the above metal elements are A and B, the oxide may be a binary metal oxide represented by (AₓB₁₋ₓ)₂O₃ (0<x<1). Alternatively, when three elements selected from the above metal elements are A, B, and C, the oxide may be a tertiary metal oxide represented by (AlₓB_{y}C_{1-x-y})₂O₃ (0<x<1, 0<y<1).

### (Stripping)

The substrate 110 may be stripped from the oxide semiconductor film. Stripping means is not limited and known means can be used. For example, examples include means for stripping by applying mechanical impact, means for stripping using thermal stress by applying heat, means for stripping by applying vibration such as ultrasound, means for stripping by etching, and laser lift-off. By the stripping, the oxide semiconductor film can be obtained as a self-supported film.

### (Electrode)

When the oxide semiconductor film and the laminate according to the present invention are applied to a semiconductor device, an electrode necessary for constructing a semiconductor device can be formed by a common method. In other words, any method such as vapor deposition, sputtering, CVD, plating, and printing for bonding together with a resin may be employed. As an electrode material, any of metals such as Al, Ag, Ti, Pd, Au, Cu, Cr, Fe, W, Ta, Nb, Mn, Mo, Hf, Co, Zr, Sn, Pt, V, Ni, Ir, Zn, In, and Nd, as well as metal oxide conductive films such as tin oxide, zinc oxide, indium oxide, indium tin oxide (ITO), and indium zinc oxide (IZO), and organic conductive compounds such as polyaniline, polythiophene, or polypyrrole can be used. An alloy or mixture of two or more of these can be used. The thickness of the electrode is preferably 1 to 1000 nm and more preferably 10 to 500 nm.

### EXAMPLE

Hereinafter, the present invention will be specifically described with reference to Examples. However, the present invention is not limited thereto.

### (Example 1)

In the present Examples, a film forming apparatus as illustrated in FIG. 17 and FIG. 18 was used. In a film forming unit 140e, two ceiling plates 153e are fixed to be in the same plane as the nozzle opening surface. When the area of the ceiling plates is B [cm²], B=600 and the difference in height position I between the substrate holding surface of the substrate holder 112 (an upper surface of the hot plate 108) and the ceiling plates was 2.05 cm.

FIG. 18 is a diagram illustrating the inside of the film forming chamber in FIG. 17 as viewed from the side in FIG. 17. As illustrated in FIG. 18, a pair of sidewalls 155e were installed on the substrate holder 112 so as to be in contact with the ceiling plate 153e. Here, the shortest distance J between the substrate holding region of the substrate holder and each of the sidewalls was set to J=2.50 cm, and IJ=5.1. The sidewalls had a thickness of 3 mm, and when the area of the facing surfaces of the sidewalls was C [cm²], C=120.

Gallium iodide was added to water and stirred at 60°C for 60 minutes to be dissolved to prepare an aqueous solution of 0.1 mol/L, which was used as the raw material solution 104a. The raw material solution 104a obtained as described above was accommodated in the mist generation source 104. The temperature of the solution at that time was 25°C.

Next, a c-plane sapphire substrate with a diameter of 4 inches (100 mm) was placed as the substrate 110 on the hot plate 108 in the film forming chamber 107, and the hot plate 108 was activated to increase the temperature to 500°C.

Subsequently, the flow control valves 103a and 103b were opened to supply a nitrogen gas as a carrier gas from the carrier gas source 102a (main carrier gas) and from the diluting carrier gas source 102b (diluting carrier gas) into the film forming chamber 107. The atmosphere in the film forming chamber 107 was sufficiently substituted with the carrier gases, and the flow rate of the main carrier gas was adjusted to 12 L/minute and the flow rate of the diluting carrier gas was adjusted to 12 L/minute.

Subsequently, using the exhaust unit 170 as illustrated in FIG. 16, the exhaust flow control valve 173 was adjusted so that the exhaust volume E [L/minute] in the exhaust port 111 was 72. Here, E/Q was 3.0.

Next, the ultrasonic transducer 106 was vibrated at 2.4 MHz, and the vibration was propagated to the raw material solution 104a through the water 105a to atomize the raw material solution 104a to generate a mist.

This mist was supplied by using the carrier gas to the substrate 110 through the supply tube 109a and the nozzle 150. As the nozzle 150, a nozzle with the nozzle opening surface 152 having a rectangular shape was used, and when the area of the nozzle opening surface 152 was S [cm²], the flow rate of the carrier gas was Q [L/minute], and the difference in height position between the nozzle opening surface 152 and the substrate 110 (the longest distance of distances between points in the nozzle opening surface 152 and the surface of the substrate 110) was H [cm], SH/Q was adjusted to 0.5. Here, S=6.0 [cm²], H=2.0 [cm], and Q=24 [L/minute].

Then, while the gas was discharged through the exhaust port 111 under atmospheric pressure at 500°C, the mist was thermally reacted in the film forming chamber 107 to form a thin film of gallium oxide (α-Ga₂O₃) having a corundum structure on the substrate 110. The film forming time was 360 minutes.

When the heating temperature was T [°C], ST/Q=125. When the area of the substrate was A [cm²], S/A=0.076. When the long-axis length of the nozzle opening surface 152 was L [cm] and the maximum length in the nozzle long-axis direction of the substrate was R [cm], L/R=1.2. Here, T=500 [°C], A=78.5 [cm²], L=12 [cm], and R=10 [cm]. Further, B/A=7.6 and C/A=1.5.

The substrate and the hot plate were allowed to reciprocate by the moving mechanism 160a as illustrated in FIG. 13 at a speed of 15 [cm/minute] and such that they passed through under the nozzle once per minute.

### (Example 2)

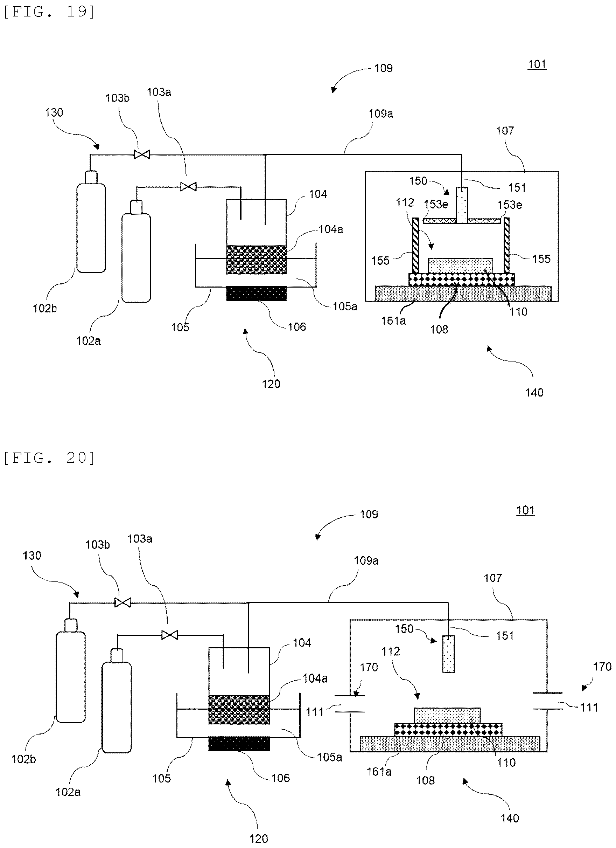

Film formation was performed in the same way as in Example 1 except that J=5.00 cm, IJ=10.3, a gap of 2.5 cm was provided between the ceiling plates 153e and the sidewalls 155 as illustrated in FIG. 19, the exhaust ports 111 were not provided, and the film forming time was 120 minutes.

### (Comparative Example 1)

Film formation was performed in the same way as in Example 1 except that a film forming apparatus as illustrated in FIG. 20 that did not have ceiling plates or sidewalls and did not satisfy IJ≤15 was used, the film forming time was 120 minutes, the flow rate Q of the carrier gas was 12 L/minute, and the flow rate E of exhaust was 36 L/minute. Here, SH/Q=1 and ST/Q=250. The shortest distance between the substrate holding region and the wall (side surface wall) of the film forming chamber was 12 cm, and the difference in height position (distance) between the substrate holding surface and the lower surface of the ceiling wall of the film forming chamber was 50 cm.

### (Comparative Example 2)

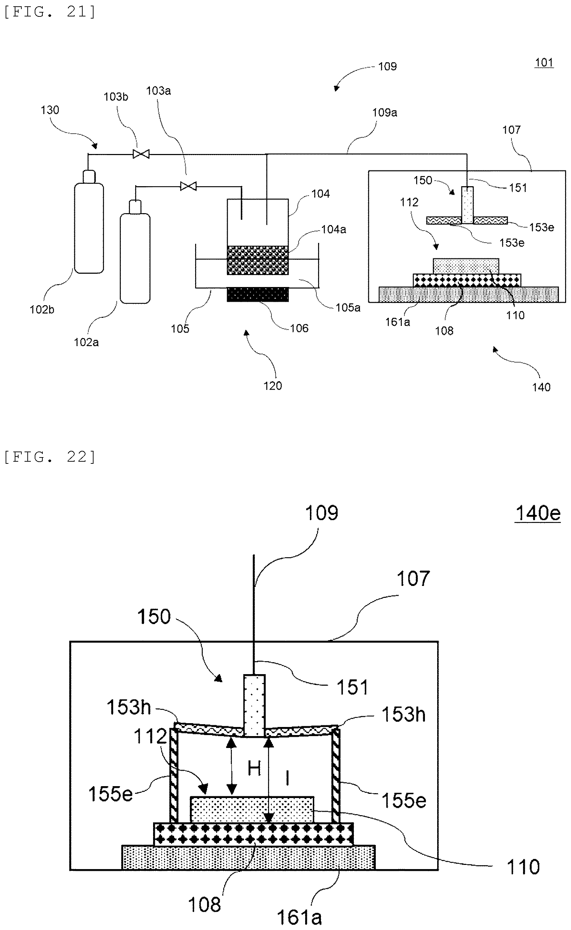

Film formation was performed in the same way as in Example 2 except that a film forming apparatus as illustrated in FIG. 21 that did not have the sidewalls 155 and did not satisfy IJ≤15 was used, and the film forming time was 20 minutes. The shortest distance between the substrate holding region and the wall (side surface wall) of the film forming chamber was 12 cm, and the difference in height position (distance) between the substrate holding surface and the bottom surface of the ceiling plate was 2.05 cm.

### (Comparative Example 3)

Film formation was performed in the same way as in Example 2 except that I=3.05 cm, H=3.00 cm, and the film forming time was 20 minutes. Here, IJ/Q=15.3 and SH/Q=0.75.

### (Comparative Example 4)

Film formation was performed in the same way as in Example 2 except that I=6.05 cm, H=6.00 cm, Q=48 L/minute, C=360 cm², and the film forming time was 40 minutes. Here, C/A=4.6, IJ=30.3, SH/Q=0.75, and ST/Q=62.5.

### (Example 3)

Film formation was performed in the same way as in Example 1 except that B=420 cm², C=360 cm², S=2.4 cm², H=6.00 cm, I=6.05 cm, J=2.00 cm, Q=48 L/minute, E=24 L/minute, and the film forming time was 60 minutes. Here, B/A=5.3, C/A=4.6, E/Q=0.5, IJ=12.1, S/A=0.030, SH/Q=0.3, and ST/Q=25.

### (Example 4)

Film formation was performed in the same way as in Example 1 except that B=750 cm², C=6 cm², S=12 cm², H=0.10 cm, I=0.15 cm, J=7.50 cm, Q=12 L/minute, E=12 L/minute, and the film forming time was 60 minutes. Here, B/A=9.5, C/A=0.1, E/Q=1.0, IJ=1.1, S/A=0.15, SH/Q=0.1, and ST/Q=500.

### (Example 5)

Film formation was performed in the same way as in Example 1 except that, in the film forming apparatus in FIG. 17, the nozzle was provided such that the nozzle opening surface 152 was immediately above an end portion of the substrate 110, the substrate was not moved, B=300 cm², and the film forming time was 300 minutes. Here, B/A was 3.8.

### (Example 6)

Film formation was performed in the same way as in Example 1 except that inclined ceiling plates as illustrated in FIG. 22 were used, J=5.00 cm, and the film forming time was 60 minutes. Here, IJ=10.3. In this case, the ceiling plates 153h are inclined such that a bottom surface on the side not in contact with the nozzle 150 is 4 mm higher than a portion in contact with the nozzle 150.

### (Example 7)

Film formation was performed in the same way as in Example 1 except that E=120 L/minute and the film forming time was 60 minutes. Here, E/Q was 5.0.

### (Example 8)

Film formation was performed in the same way as in Example 1 except that E=360 L/minute and the film forming time was 60 minutes. Here, E/Q was 15.0.

### (Example 9)

Film formation was performed in the same way as in Example 1 except that the substrate was a 6-inch (150 mm in diameter) c-plane sapphire substrate, B=1000 cm², S=9 cm², Q=36 L/minute, E=36 L/minute, and the film forming time was 60 minutes. Here, A=177 cm², B/A=5.7, C/A=0.7, E/Q=1.0, S/A=0.05, R=15 cm, and L=18 cm.

### (Example 10)

Film formation was performed in the same way as in Example 1 except that, in the film forming apparatus in FIG. 17, the nozzle was provided such that the nozzle opening surface 152 was immediately above an end portion of the substrate 110, the substrate was not moved, the substrate was a 6-inch (150 mm in diameter) c-plane sapphire substrate, B=500 cm², C=30 cm², S=9 cm², Q=36 L/minute, E=36 L/minute, and the film forming time was 60 minutes. Here, A=177 cm², B/A=2.8, C/A=0.2, E/Q=1.0, S/A=0.05, R=15 cm, and L=18 cm.

### (Example 11)

Film formation was performed in the same way as Example 1 except that an aluminum acetylacetonate complex was dissolved in a hydrochloric acid solution to prepare a solution of 0.1 mol/L, which was used as a raw material solution, H=3.00 cm, I=3.05 cm, J=3.00 cm, T=550°C, and the film forming time was 45 minutes. Here, IJ=9.2, SH/Q=0.75, and ST/Q=137.5.

### (Example 12)

Film formation was performed in the same way as in Example 5 except that gallium nitrate was dissolved in water to prepare a solution of 0.1 mol/L, which was used as a raw material solution, B=40 cm², E=24 L/minute, and the film forming time was 45 minutes. Here, E/Q=1.0, and B/A=0.5.

### (Film Thickness Distribution Measurement)

For a thin film formed on the substrate 110, film thicknesses at 25 points in plane on the substrate 110 were measured by using an optical interferometry film thickness measuring system F50. The average film thickness was calculated from the measured values and listed in Table 1. Further, a film thickness distribution calculated by the following was listed in Table 1: film thickness distribution [±%]=(maximum film thickness-minimum film thickness)/((average film thickness) × 2) × 100.

Further, a film formation rate was obtained by dividing the average film thickness by the film forming time, and listed in Table 1. A plot of in-plane distribution of film thickness against IJ is provided in FIG. 23.

**[Table 1]**

| | B/A [-] | C/A [-] | E/Q [-] | I [cm] | J [cm] | IJ [cm²] | Substrate movement | Film thickness [µm] | Film formation rate [µm/h] | Distribution [±%] |
|---|---|---|---|---|---|---|---|---|---|---|
| Example 1 | 7.6 | 1.5 | 3.0 | 2.05 | 2.50 | 5.1 | Reciprocate | 7.40 | 1.2 | 2.2 |
| Example 2 | 7.6 | 1.5 | - | 2.05 | 5.00 | 10.3 | Reciprocate | 2.50 | 1.3 | 3.4 |
| Comparative Example 1 | - | - | 3.0 | - | 12.00 | - | Reciprocate | 1.50 | 0.8 | 51.2 |
| Comparative Example 2 | 7.6 | - | - | 2.05 | 12.00 | 24.6 | Reciprocate | 0.25 | 0.8 | 9.1 |
| Comparative Example 3 | 7.6 | 1.5 | - | 3.05 | 5.00 | 15.3 | Reciprocate | 0.22 | 0.7 | 5.9 |
| Comparative Example 4 | 7.6 | 4.6 | - | 6.05 | 5.00 | 30.3 | Reciprocate | 0.30 | 0.5 | 15.8 |
| Example 3 | 5.3 | 4.6 | 0.5 | 6.05 | 2.00 | 12.1 | Reciprocate | 0.90 | 0.9 | 4.7 |
| Example 4 | 9.5 | 0.1 | 1.0 | 0.15 | 7.50 | 1.1 | Reciprocate | 2.00 | 2.0 | 4.1 |
| Example 5 | 3.8 | 1.5 | 3.0 | 2.05 | 2.50 | 5.1 | None | 6.30 | 1.3 | 4.6 |
| Example 6 | 7.6 | 1.5 | 3.0 | 2.05 | 5.00 | 10.3 | Reciprocate | 1.24 | 1.2 | 3.6 |
| Example 7 | 7.6 | 1.5 | 5.0 | 2.05 | 2.50 | 5.1 | Reciprocate | 1.08 | 1.1 | 2.8 |
| Example 8 | 7.6 | 1.5 | 15.0 | 2.05 | 2.50 | 5.1 | Reciprocate | 0.94 | 0.9 | 4.8 |
| Example 9 | 5.7 | 0.7 | 1.0 | 2.05 | 2.50 | 5.1 | Reciprocate | 1.05 | 1.1 | 2.7 |
| Example 10 | 2.8 | 0.2 | 1.0 | 2.05 | 2.50 | 5.1 | None | 1.24 | 1.2 | 4.8 |
| Example 11 | 7.6 | 1.5 | 3.0 | 3.05 | 3.00 | 9.2 | Reciprocate | 0.87 | 1.2 | 4.2 |
| Example 12 | 0.5 | 1.5 | 1.0 | 2.05 | 2.50 | 5.1 | None | 0.75 | 1.0 | 3.7 |

As shown in Table 1 and FIG. 23, the comparison of Examples 1 to 12 with Comparative Examples 1 to 4 has indicated that film formation by using the film forming apparatus according to the present invention results in a gallium oxide (α-Ga₂O₃) film with excellent in-plane uniformity of film thickness distribution. The invention described in Patent Document 5 above failed to provide a film with good in-plane uniformity of film thickness distribution on a substrate with a diameter of 4 inches (100 mm) or larger, presumably because it differs from the present invention in the presence/absence of a mechanism that regulates a flow of mist.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A film forming apparatus comprising:
an atomizer configured to atomize a raw material solution to generate a mist;
a carrier gas supplier configured to supply a carrier gas that conveys the mist generated by the atomizer; and
a film forming unit configured to heat the mist conveyed by the carrier gas to form a film, wherein
the film forming unit includes
a substrate holder configured to hold the substrate,
a nozzle located above the substrate holder and configured to supply the mist onto the substrate,
a ceiling plate located above the substrate holder and configured to regulate a flow of the mist supplied from the nozzle, and
sidewalls facing each other with the substrate holder interposed, and
when a difference in height position between a substrate holding surface of the substrate holder and a bottom surface of the ceiling plate is I [cm] and a shortest distance between a substrate holding region of the substrate holder and each of the sidewalls is J [cm], IJ≤15 holds.

2. The film forming apparatus according to claim 1, wherein all of the bottom surface of the ceiling plate, an opening surface of the nozzle, and the substrate holding surface are parallel.

3. The film forming apparatus according to claim 1 or 2, wherein the I [cm] is 0.15 cm or more and 6.05 cm or less.

4. The film forming apparatus according to any one of claims 1 to 3, wherein the J [cm] is 5.0 cm or less.

5. The film forming apparatus according to any one of claims 1 to 4, wherein when the bottom surface of the ceiling plate has an area of B [cm²], B≥40 holds.

6. The film forming apparatus according to any one of claims 1 to 5, wherein when a surface to be processed of the substrate has an area of A [cm²] and the bottom surface of the ceiling plate has an area of B [cm²], B/A≥0.5 holds.

7. The film forming apparatus according to any one of claims 1 to 6, wherein when surfaces of the sidewalls on the substrate holder side have an area of C [cm²], C≥20 holds.

8. The film forming apparatus according to any one of claims 1 to 7, wherein when a surface to be processed of the substrate has an area of A [cm²] and facing surfaces of the sidewalls have an area of C [cm²], C/A≥0.2 holds.

9. The film forming apparatus according to any one of claims 1 to 8, further comprising an exhaust unit configured to discharge an exhaust gas from the film forming unit.

10. The film forming apparatus according to any one of claims 1 to 9, further comprising a moving mechanism configured to move the substrate below the nozzle.

11. The film forming apparatus according to any one of claims 1 to 9, wherein the film forming unit includes a film forming chamber, and the sidewalls are walls of the film forming chamber.

12. The film forming apparatus according to any one of claims 1 to 10, wherein the film forming unit further includes a film forming chamber configured to accommodate the substrate holder, the nozzle, the ceiling plate, and the sidewalls inside.

13. A film forming method in which a film is formed on a substrate by heating a mist of a raw material solution, the film forming method comprising:
a mist generating step of atomizing the raw material solution to generate a mist;
a mist conveying step of conveying the mist to a film forming unit;
a film forming step of forming a film by supplying the mist onto the substrate placed on a substrate holder in the film forming unit from a nozzle located above the substrate holder, and heating the mist,
wherein
in the film forming step,
the mist is supplied from the nozzle into a space surrounded by a ceiling plate provided above the substrate holder and by sidewalls facing each other with the substrate holder interposed, wherein a difference in height position between a substrate holding surface of the substrate holder and a bottom surface of the ceiling plate is I [cm], and a shortest distance between a substrate holding region of the substrate holder and each of the sidewalls is J [cm], wherein the ceiling plate and the sidewalls are provided such that IJ≤15 holds.

14. The film forming method according to claim 13, wherein the ceiling plate and the sidewalls are provided such that all of the bottom surface of the ceiling plate, an opening surface of the nozzle, and the substrate holding surface are parallel.

15. The film forming method according to claim 13 or 14, wherein the ceiling plate is provided such that the difference I [cm] in height position between the substrate holding surface of the substrate holder and the bottom surface of the ceiling plate is 0.15 cm or more and 6.05 cm or less.

16. The film forming method according to any one of claims 13 to 15, wherein the sidewalls are provided such that the J [cm] is 5.0 cm or less.

17. The film forming method according to any one of claims 13 to 16, wherein the ceiling plate is provided such that when the bottom surface of the ceiling plate has an area of B [cm²], B≥40 holds.

18. The film forming method according to any one of claims 13 to 17, wherein the ceiling plate is provided such that when a surface to be processed of the substrate has an area of A [cm²] and the bottom surface of the ceiling plate has an area of B [cm²], B/A≥0.5 holds.

19. The film forming method according to any one of claims 13 to 18, wherein the sidewalls are provided such that when surfaces of the sidewalls on the substrate holder side have an area of C [cm²], C≥20 holds.

20. The film forming method according to any one of claims 13 to 19, wherein the sidewalls are provided such that when a surface to be processed of the substrate has an area of A [cm²] and facing surfaces of the sidewalls have an area of C [cm²], C/A≥0.2 holds.

21. The film forming method according to any one of claims 13 to 20, further comprising an exhaust step of discharging an exhaust gas from the film forming unit.

22. The film forming method according to claim 21, wherein when the carrier gas supplied from the nozzle has a flow rate of Q [L/minute] and the exhaust gas has a flow rate of E [L/minute], E/Q is set to 5.0 or less.

23. The film forming method according to any one of claims 13 to 22, wherein the substrate is moved below the nozzle.

24. The film forming method according to any one of claims 13 to 23, wherein a solution containing gallium is used as the raw material solution.

25. The film forming method according to any one of claims 13 to 24, wherein a solution containing halogen is used as the raw material solution.

26. The film forming method according to any one of claims 13 to 25, wherein a substrate with a surface to be processed having an area of 50 cm² or more or a diameter of 4 inches (100 mm) or more is used as the substrate.

27. An oxide semiconductor film comprising gallium as a main component, wherein
the oxide semiconductor film has an area of 70 cm² or more or a surface size of 4 inches (100 mm) or more in diameter, and
the oxide semiconductor film has a film thickness with an in-plane distribution of less than ±5%.

28. The oxide semiconductor film according to claim 27, wherein the oxide semiconductor film has a corundum structure.

29. A laminate of an oxide semiconductor film and a substrate, the oxide semiconductor film comprising gallium as a main component, wherein
the oxide semiconductor film of the laminate has an area of 70 cm² or more or a surface size of 4 inches (100 mm) or more in diameter, and
the oxide semiconductor film has a film thickness with an in-plane distribution of less than ±5%.

30. The laminate according to claim 29, wherein the oxide semiconductor film has a corundum structure.
